# EUROPEAN PATENT SPECIFICATION

(11) **EP 2 796 929 B1**
(45) Date of publication and mention of the grant of the patent: **30.12.2015**
(21) Application number: 14169634.4
(22) Date of filing: 29.02.2012
(51) Int. Cl.: G03F 7/039, B41C 1/10, B41M 5/36

(54) **Lithographic printing plate precursor and method of preparing the same**
Lithographiedruckplattenvorläufer und Verfahren zur Herstellung davon
Précurseur de plaque d'impression lithographique et son procédé de préparation

(30) Priority: 31.03.2011 JP 2011081065; 31.03.2011 JP 2011081066; 31.03.2011 JP 2011081067; 30.01.2012 JP 2012016694; 31.01.2012 JP 2012018134
(43) Date of publication of application: 29.10.2014
(62) Divisional of application: 12157456.0
(73) Proprietor: Fujifilm Corporation, Minato-ku Tokyo 106-8620 (JP)
(72) Inventor: Fujii, Shigekatsu, Haibara-gun, Shizuoka 421-0396 (JP); Aoshima, Norio, Haibara-gun, Shizuoka 421-0396 (JP); Taguchi, Yoshinori, Haibara-gun, Shizuoka 421-0396 (JP); Ara, Yoichiro, Haibara-gun, Shizuoka 421-0396 (JP); Aridomi, Takashi, Haibara-gun, Shizuoka 421-0396 (JP)
(74) Representative: Hoffmann Eitle

(56) References cited:
- US-A1- 2005 214 678

## Description

### FIELD OF THE INVENTION

The present invention relates to a lithographic printing plate precursor and a method of making a lithographic printing plate therefrom.

### BACKGROUND OF THE INVENTION

The progress has astonishingly been made, in the technology relating to laser exposure and development of lithographic printing. Especially, it can be noted that a high power and compact device has been available, without difficulties, for the solid laser and the semiconductor laser each of which has an emitting region in the range of from near-infrared to infrared. These lasers are extremely useful as an exposure source, for making a plate directly from digital data of a computer and the like. Accordingly, it is extremely important to develop a lithographic printing plate precursor that properly copes with this type of the plate making.

The recording layer of a positive type lithographic printing plate precursor for infrared laser contains, as essential components, an alkali-soluble binder resin and an IR dye or the like that absorbs light to generate heat. This IR dye or the like in the unexposed area (image area) acts as a development inhibitor that substantially reduces solubility with respect to a developing solution for the binder resin due to interaction with the binder resin. Meanwhile, in the exposed area (non-image area), an interaction between the IR dye or the like and the binder resin is weakened due to the generated heat, and the binder resin is dissolved in an alkali developing solution to form a lithographic printing plate.

The basic performance required for the lithographic printing plate precursor includes developability that rapidly realizes formation of a vivid image area, and in contrast, chemical resistance by which the recording layer in the unexposed area is accurately retained without being dissolved, and improvement in plate durability that increases print capacity. However, these performances are generally conflicting. Accordingly, it is extremely difficult to improve all the performances at the same time. For example, in JP-A-2007-017913 ("JP-A" means an unexamined publication of Japanese patent application), Japanese Patent No. 4579639 and JP-T-2010-532488 ("JP-T" means published Japanese translation of PCT application), incorporation of a particular polymer into a recording layer of the printing plate precursor disclosed therein has been proposed.

Normally, when a polymer having a large molecular weight is incorporated in a recording layer, improvement in plate durability and chemical resistance in accordance with it can be expected. However, that tends to reduce developability. As a result, it is difficult to improve all the performances with a balanced manner.

### SUMMARY OF THE INVENTION

As a method of enhancing developability of a polymer, a method of adding a surfactant to a developing solution is known. Generally, in the processing of the positive type lithographic printing plate precursor for infrared laser, it is necessary to stabilize the liquid activity in order to perform a processing continuously and stably. The liquid activity is controlled by an alkali concentration (pH, conductivity, etc.). However, in a case where a surfactant is added to a developing solution, a continuous use of the developing solution makes it difficult to keep a concentration of the surfactant constant. As a result, the concentration of the surfactant gradually increases, which sometimes results in reduction of chemical resistance. On the contrary, when the concentration of the surfactant diminishes, that sometimes results in reduction of developability.

In view of the techniques disclosed by the above-described patent literatures, the present invention addresses provision of a lithographic printing plate precursor that realizes both high plate durability and high chemical resistance in the lithographic printing, with good developability in the exposed area, suppression of a running residue (hereinafter also referred to as "developing residue), and a good concentration performance of a developing waste liquid.

As a result of intensive studies in view of achieving the above subjects, the present inventors have found the following knowledge. That is, the presence of both a particular polymer and a particular surfactant in a recording layer of a positive type lithographic printing plate precursor for infrared laser makes it possible for the surfactant to be stably supplied to the developing system. This leads to realization of a high degree of plate durability, and also achievement of good developability in the exposed area. The present invention has been made on the basis of the above new findings.

According to a first aspect, the present invention provides an infrared sensitive lithographic printing plate precursor of positive-type comprising a support having a hydrophilic surface and an image recording layer provided on the support comprising:
an anionic surfactant;
an infrared absorbing agent; and
a polyuretheane resin,
wherein the image recording layer has a configuration in which a lower layer on the side of the support and an upper layer on the side opposite thereto are disposed on the support in this order, the upper layer and/or the lower layer comprising the polyurethane resin, the anionic surfactant and the infrared absorbing agent in the same layer, or in a separate layer.

Preferably the anionic surfactant is represented by any one of formulae (IV) to (VII):

**R⁶-L¹²-D¹** (IV)

**R⁷-L¹³-E¹** (V)

**R⁸-L¹⁴-F¹** (VI)

**R⁹-L¹⁵-G¹-L¹⁶** (VII)

wherein R⁶ and R⁹ each represent an alkyl group having 6 to 24 carbon atoms; L¹² represents a phenylene group or a single bond; D¹, E¹ and F¹ each represent an sulfonate ion or a salt thereof, or an phosphate ion or a salt thereof; R⁷ represents an alkyl group having 4 to 18 carbon atoms; L¹³ represents a phenylene group or a naphthylene group; R⁸ represents a phenyl group or a naphthyl group; L¹⁴ represents a polyalkyleneoxy group; L¹⁵ represents a phenylene group; G¹ represents an oxygen atom; and L¹⁶ represents a phenyl group.

Preferably the polyurethane resin is a polymerization product of at least a diisocyanate compound selected from the following DI-1 to DI-4 and a diol compound selected from the following DO-1 to DO-5.

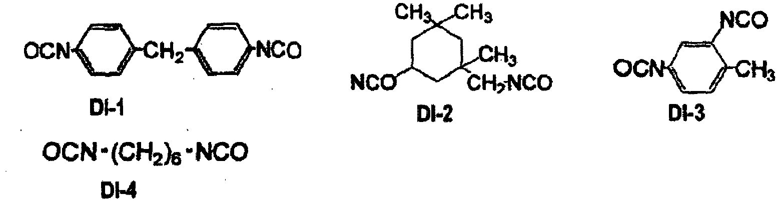

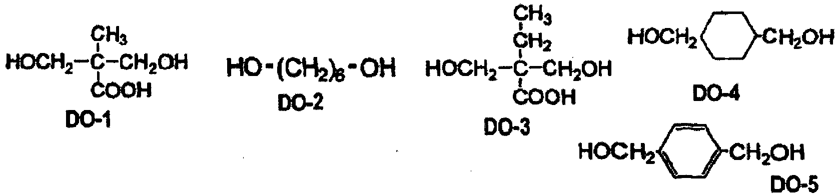

Preferably the anionic surfactant is contained in an amount of 1% by mass or more and less than 20% by mass with respect to the total amount of the solid content of the layer containing the same, and the anionic surfactant and the infrared absorbing agent are contained in the same layer, or in a separate layer.

Preferably the anionic surfactant is contained in an amount of from 0.5% by mass to 40% by mass with respect to 100% by mass of the polyurethane resin.

Preferably the infrared sensitive lithographic printing plate precursor further comprises an undercoat layer between the support and the lower layer of the recording layer.

Preferably the polyurethane resin is contained in the upper layer of the recording layer.

Preferably the anionic surfactant is contained in the same layer as the layer containing the polyurethane resin.

Preferably:
(i) the upper layer of the image recording layer comprises an alkali soluble or dispersible resin, the polyurethane resin, the surfactant and a Novolac resin; and the lower layer of the image recording layer comprises the infrared absorbing agent;
(ii) the upper layer of the image recording layer comprises the polyurethane resin, the surfactant and a Novolac resin; and the lower layer of the image recording layer comprises an alkali soluble or dispersible resin and the infrared absorbing agent;
(iii) the upper layer of the image recording layer comprises an alkali soluble or dispersible resin, the polyurethane resin and a Novolac resin; and the lower layer of the image recording layer comprises the surfactant and the infrared absorbing agent;
(iv) the upper layer of the image recording layer comprises the polyurethane resin and the surfactant; and the lower layer of the image recording layer comprises an alkali soluble or dispersible resin and the infrared absorbing agent;
(v) the upper layer of the image recording layer comprises the polyurethane resin and the surfactant; and the lower layer of the image recording layer comprises an alkali soluble or dispersible resin, a Novolac resin and the infrared absorbing agent; or
(vi) the upper layer of the image recording layer comprises the polyurethane resin, the surfactant and the infrared absorbing agent; and the lower layer of the image recording layer comprises an alkali soluble or dispersible resin, a Novolac resin and the infrared absorbing agent.

According to a second aspect, the present invention provides a method of making a lithographic printing plate comprising:
subjecting the recording layer of the infrared sensitive lithographic printing plate precursor according to the above first aspect to image-wise exposure; and
developing the exposed lithographic printing plate precursor using an aqueous alkaline solution which has a pH of from 11.0 to 13.5.

Preferably the aqueous alkaline solution comprises an anionic surfactant or a nonionic surfactant.

### BRIEF DESCRIPTION OF THE DRAWING

Fig. 1 is a sectional view schematically showing an embodiment in which a lithographic printing plate precursor of the present invention has a multilayer structure as a recording layer.
Fig. 2 is a sectional view schematically showing an embodiment in which a lithographic printing plate precursor of the present invention has a single layer structure as a recording layer.

### <Explanation of Symbols>

1: image recording layer
3: undercoat layer
4: support
11: upper layer of the recording layer
12: lower layer of the recording layer
10 and 20: lithographic printing plate precursor

### DETAILED DESCRIPTION OF THE INVENTION

Details of the present invention are described below.

### <Lithographic Printing Plate Precursor>

The lithographic printing plate precursor of the present invention has an image recording layer above the support having a hydrophilic surface, the image recording layer containing a polyurethane resin (a), and an anionic surfactant (b). When the recording layer is separated into a lower layer and an upper layer, the components (a) and (b) may be added to the upper layer or the lower layer, and each of them may be added to the same layer, or may be added to the separate layers. The lower layer and the upper layer are disposed above the support in this order. If needed, other layers, for example, optional layers such as an undercoat layer or a protective layer, may be further present above the support. In the present invention, it is preferable from the viewpoint of effect that the lower layer and the upper layer are formed adjacent to each other.

The reason (mechanism of action) to produce the effect of simultaneous achievement of plate durability, chemical resistance and developability due to the use of the above configuration in the present invention includes unexplained points. However, the reason is presumed as follows. That is, the amphoteric surfactant and the anionic surfactant have higher hydration force and dispersion force than the nonionic or cationic surfactant. Accordingly, it is assumed that addition of the amphoteric surfactant or the anionic surfactant to the recording layer produces high effects in a smaller amount than the nonionic or cationic surfactant. As a result, it seems that a desirable effect may be produced in combination with the action of the above-described particular polymer without reducing chemical resistance and the like of the recording layer.

### <Particular Resin>

### (Polyurethane Resin)

The image recording layer constituting the lithographic printing plate precursor of the present invention contains a polyurethane which has a substituent having an acidic hydrogen atom. The acidic hydrogen atom may belong to an acidic functional group such as a carboxyl group, -SO₂NHCOO- group, -CONHSO₂- group, - CONHSO₂NH- group or -NHCONHSO₂- group, but is particularly preferably derived from a carboxyl group.

The polyurethane having an acidic hydrogen atom can be synthesized by a method of reacting a diol having a carboxyl group and, if necessary, another diol and a diisocyanate; a method of reacting a diol, a diisocyanate having a carboxyl group and, if necessary, another diisocyanate; or a method of reacting a diol having a carboxyl group and, if necessary, another diol, a diisocyanate having a carboxyl group and, if necessary, another diisocyanate.

Examples of the diol having a carboxyl group include 3,5-dihydroxybenzoic acid, 2,2-bis(hydroxymethyl)propionic acid, 2,2-bis(hydroxyethyl)propionic acid, 2,2-bis(3-hydroxypropylpropionic acid, 2,2-bis(hydroxymethyl)acetic acid, bis-(4-hydroxyphenyl)acetic acid, 4,4-bis-(4-hydroxyphenyl)pentanoic acid and tartaric acid, and 2,2-bis(hydroxymethyl)propionic acid is more preferable in view of reactivity with isocyanate.

Examples of the other diol include dimethylolpropane, polypropylene glycol, neopentyl glycol, 1,3-propanediol, polytetramethylene ether glycol, polyesterpolyol, polymerpolyol, polycaprolactonepolyol, polycarbonatediol, 1,4-butanediol, 1,5-pentadiol, 1,6-hexanediol and polybutadienepolyol.

Examples of the diisocyanate having a carboxyl group include dimer acid diisocyanate.

Examples of the other diisocyanate include 4,4'-diphenylmethane diisocyanate, xylylene diisocyanate, naphthylene-1,5-diisocyanate, tetramethylxylene diisocyanate, hexamethylene diisocyanate, toluene-2,4-diisocyanate, isophorone diisocyanate, hydrogenated xylylene diisocyanate, dicyclohexylmethane diisocyanate, norbornane diisocyanate and trimethylhexamethylene diisocyanate.

The molar ratio of the diisocyanate to the diol is preferably from 0.7:1 to 1.5:1. In case an isocyanate group remains at the end of the polymer, by treating the isocyanate with alcohols or amines, synthesis is finally conducted without remaining the isocyanate group.

The weight average molecular weight of the above-described particular polyurethane is preferably within a range from 2,000 to 100,000. When the weight average molecular weight of the polyurethane is less than 2,000, the image area obtained by forming images tends to be insufficient in durability, resulting in poor printing durability. On the other hand, when the weight average molecular weight of the polyurethane is more than 100,000, developability and sensitivity tends to be poor.

The above-described particular polyurethane is preferably alkali soluble or dispersible.

The content of the particular polyurethane in the recording layer is preferably within a range from 2 to 90% by mass, more preferably within a range from 50 to 90% by mass, based on the total solid content of the layer containing the polyurethane. It is advantageous from the viewpoint of plate durability that the content of the particular polyurethane is not less than the above-described lower limit. It is advantageous from the viewpoint of developability that the content of the particular polyurethane is not more than the above-described upper limit. If necessary, two or more kinds of the particular polyurethanes may be used in combination.

### (Phenolic resin)

Various phenolic resins can also be used in the recording layer in the embodiments. Examples of the phenolic resins include hosphor resins such as condensation polymers of phenol and formaldehyde, condensation polymers of m-cresol and formaldehyde, condensation polymers of p-cresol and formaldehyde, condensation polymers of m-/p-mixed cresol and formaldehyde, condensation polymers of phenol, cresol (m-, p-, or m-p-mixture) and formaldehyde, and condensation copolymers of pyrogallol and acetone. Further, copolymers obtained by copolymerizing compound containing phenol groups in the side chains can be used. Mixtures of such polymeric binders can also be used.

Novolac resins having a weight average molecular weight of at least 1500 and a number average molecular weight of at least 300 are useful. Generally, the weight average molecular weight is in the range of from 3,000 to 300,000, the number average molecular weight is from 500 to 250,000, and the degree of dispersion (weight average molecular weight/number average molecular weight) is in the range of from 1.1 to 10.

Certain mixtures of the primary polymeric binders described above can be used, including mixtures of one or more poly(vinyl acetals) and one or more phenolic resins. For example, mixtures of one or more poly(vinyl acetals) and one or more hosphor or resol resins (or both hosphor and resol resins) can be used.

The lithographic printing plate precursor according to the present invention may contain a secondary polymeric binder. Herein, the secondary polymeric binder refers to a resin which can be used in combination with the above primary polymer binder. The secondary polymeric binder is generally an alkali-soluble resin from the view point of not diminishing the positive-type photosensitivity of the lithographic printing plate precursor.

### <Acidic group-containing polymer>

Examples of secondary polymeric binders include the following classes of polymers having an acidic group in (1) through (5) shown below on a main chain and/or side chain (pendant group).
(1) Sulfone amide group (-SO₂NH-R)
(2) Substituted sulfonamido based acid group (hereinafter, referred to as active imido group) [such as -SO₂NHCOR, -SO₂NHSO₂R, -CONHSO₂R]
(3) Carboxylic acid group (-CO₂H)
(4) Sulfonic acid group (-SO₃H)
(5) Phosphoric acid group (-OPO₃H₂)

R in the above-mentioned groups (1) to (5) represents a hydrogen atom or a hydrocarbon group.

Representative secondary polymeric binders having a sulfone amide group of the substituent (1) are, for instance, polymers that are constituted of a minimum constituent unit as a main component derived from a compound having a sulfone amide group. Thus, examples of such a compound include a compound having, in a molecule thereof, at least one sulfone amide group in which at least one hydrogen atom is bound to a nitrogen atom and at least one polymerizable unsaturated group. Among these compounds are m-aminosulfonylphenyl methacrylate, N-(p-aminosulfonylphenyl)methacrylamide, and N-(p-aminosulfonylphenyl)acrylami de. Thus, a homopolymer or a copolymer of polymerizing monomers having a sulfoneamide group such as m-aminosulfonylphenyl methacrylate, N-(p-aminosulfonylphenyl) methacryl amide, or N-(p-aminosulfonylphenyl) acrylamide can be used.

Examples of the secondary polymeric binders with an activated imido group of the substituent (2) are polymers containing recurring units derived from compounds having activated imido group as the main constituent component. Examples of such compounds include polymerizable unsaturated compounds having a moiety defined by a structural formula-(CO)(NH)(SO₂)-.

N-(p-toluenesulfonyl) methacrylamide and N-(p-toluenesulfonyl) acrylamide are examples of such polymerizable compounds.

Secondary polymeric binders having any of the substituents (3) through (5) include those readily prepared by reacting ethylenically unsaturated polymerizable monomers having the desired acidic groups, or groups that can be converted to such acidic groups after polymerization.

Regarding the minimum constituent units having an acidic group that is selected from the substituents (1) through (5), there is no need to use only one kind of acidic group in the polymer, and in some embodiments, it may be useful to have at least two kinds of acidic groups. Obviously, not every recurring unit in the secondary polymeric binder must have one of the acidic groups, but usually at least 10 mole % and typically at least 20 mole % contain the recurring units having one of the above-mentioned acidic groups.

The acid group-containing polymer can have a weight average molecular weight of at least 2,000 and a number average molecular weight of at least 500. Typically, the weight average molecular weight is from 5,000 to 300,000, the number average molecular weight is from 800 to 250,000, and the degree of dispersion (weight average molecular weight/number average molecular weight) is from 1.1 to 10.

The acid group-containing polymer may be used with the one or more primary polymeric binders. The content of the acid group-containing polymer is not particularly limited, but preferably at least 1% by mass and not more than 50% by mass, and more preferably from 5% by mass to 30% by mass.

Regarding the description of the group (atomic groups) in the present specification, the description in which neither "substitution" nor "non-substitution" is labeled includes those having no substituent as well as those having a substituent. For example, the term "alkyl group" includes not only an alkyl group having no substituent (an unsubstituted alkyl group), but also an alkyl group having a substituent (a substituted alkyl group). In the present specification, the *** compound or resin, or polymer means to embrace the compound itself, and in addition thereto, a salt thereof and an ion or the like thereof. Typically, this compound means the compound and/or a salt thereof. The same goes for the surfactant described below. Accordingly, the compound described therein may be present as an ion thereof without a counter ion, or alternatively may be a salt thereof.

Herein, the molecular weight and the degree of dispersion are values obtained by measurement in accordance with GPC (gel permeation chromatography) method, unless otherwise specified. The molecular weight is defined as a weight-average molecular weight in polystyrene equivalent. The gel packed in the column used for GPC method is preferably a gel having an aromatic compound in the repeating unit, and examples thereof include a gel comprising a styrene-divinylbenzene copolymer. Two to six columns are preferably connected and used. The solvent used includes an ether-based solvent such as tetrahydrofuran, and an amide-based solvent such as N-methylpyrrolidinone. The measurement is preferably performed at a solvent flow rate of 0.1 to 2 mL/min, most preferably from 0.5 to 1.5 mL/min. When the measurement is performed in this range, the measurement can be performed more efficiently without imposing a load on the apparatus. The measurement temperature is preferably from 10°C to 50°C, and most preferably from 20°C to 40°C. The column and the carrier used in this measurement may be selected appropriately in accordance with physical properties of the polymer to be measured.

### <Surfactant>

### (Anionic Surfactant)

Preferred examples of the anionic surfactant include the anionic surfactant represented by any one of formulae (IV) to (VII).

R⁶-L¹²-D¹ (IV)

R⁷-L¹³-E¹ (V)

R⁸-L¹⁴-F¹ (VI)

R⁹-L¹⁵-G¹-L¹⁶ (VII)

In formulae (IV) to (VII), R⁶ and R⁹ each independently represent an alkyl group having 6 to 24 carbon atoms. L¹² represents a phenylene group or a single bond. D¹, E¹ and F¹ each independently represent a sulfonate ion or a salt thereof, or a sulfate ion or a salt thereof. R⁷ represents an alkyl group having 4 to 18 carbon atoms. L¹³ represents a phenylene group or a naphthylene group. R⁸ represents a phenyl group or a naphthyl group. L¹⁴ represents a polyalkyleneoxy group. L¹⁵ represents a phenylene group. G¹ represents an oxygen atom. L¹⁶ represents a phenyl group.

Examples of the anionic surfactant include fatty acid salts, abietic acid salts, hydroxyalkane sulfonates, alkane sulfonates, dialkyl sulfosuccinates, linear alkylbenzene sulfonates, branched alkylbenzene sulfonates, alkyl naphthalene sulfonates, alkyl phenoxy polyoxyethylene propyl sulfonates, polyoxyethylene alkyl sulfophenyl ether salts, N-methyl-N-oleyl taurine sodiums, N-alkylsulfosuccinic acid monoamide disodium salts, petroleum sulfonates, sulfated castor oil, sulfated beef tallow oil, sulfates of fatty acid alkyl esters, alkyl sulfate salts, polyoxyethylene alkyl ether sulfate salts, fatty acid monoglyceride sulfate salts, polyoxyethylene alkylphenyl ether sulfate salts, polyoxyethylene styryl phenyl ether sulfate salts, alkyl phosphate salts, polyoxyethylene alkyl ether phosphate salts, polyoxyethylene alkyl phenyl ether phosphate salts, partially saponified styrene-maleic acid anhydride copolymers, partially saponified olefin-maleic acid anhydride copolymers, naphthalene sulfonate formalin condensates, aromatic sulfonates, and aromatic substituted polyoxyethylene sulfonates. Among them, a dialkylsulfosuccinate salt, an alkylsulfate ester salt, or an alkylnaphthalenesulfonate salt is preferably used.

As for the anionic surfactant used in the developing solution in the present invention, anionic surfactants containing a sulfonic acid or a sulfonate are especially preferable. The anionic surfactant may be used singly or in combination.

The content of the above-described anionic surfactant is not particularly limited in the present invention, but generally from more than 1% by mass to less than 20% by mass, preferably from 3% by mass to 15% by mass, and more preferably from 5% by mass to 10% by mass, with respect to the total solid content of the layer containing the surfactant (an upper layer as an example). Setting of the content to the above-described lower limit or more makes it possible to effectively suppress generation of a running residue in particular, which is favorable. Meanwhile, setting of the content to the above-described upper limit or less makes it possible to suppress film wearing and to get sufficient plate durability, which is favorable. In a relationship with the above-described particular resin, from the same viewpoint as described above, the content of the amphoteric surfactant or anionic surfactant is preferably from 0.5 part by mass to 40 parts by mass, more preferably from 1 part by mass to 18 parts by mass, and still more preferably from 1 part by mass to 16 parts by mass, with respect to 100 parts by mass of the particular resin. Setting of the content to the above-described lower limit or more makes it possible to effectively suppress generation of a running residue in particular, which is favorable.

### (Other Surfactant)

The developing solution may contain nonionic surfactants, cationic surfactants or the like other than the above-described surfactants, as far as the effect of the present invention is not undermined.

Examples of the nonionic surfactant include a polyethylene glycol type higher alcohol ethylene oxide adduct, an alkylphenol ethylene oxide adduct, a polyethylene glycol adduct of an aromatic compound, a fatty acid ethylene oxide adduct, a polyhydric alcohol fatty acid ester ethylene oxide adduct, a higher alkylamine ethylene oxide adduct, a fatty acid amide ethylene oxide adduct, an ethylene oxide adduct of an oil or fat, a polypropylene glycol ethylene oxide adduct, a dimethylsiloxane-ethylene oxide block copolymer, a dimethylsiloxane-(propylene oxide-ethylene oxide) block copolymer, a polyhydric alcohol type glycerol fatty acid ester, a pentaerythritol fatty acid ester, sorbitol and sorbitan fatty acid esters, a sucrose fatty acid ester, a polyhydric alcohol alkyl ether, and an alkanolamine fatty acid amide.

The above-described nonionic surfactant preferably includes a nonionic aromatic ether-type surfactant, and more preferably adducts of ethyleneoxide and/or propyleneoxide of phenol or naphthol, which may have a nondissociative substituent. This surfactant may be used singly or in combination of two or more kinds.

Examples of the cationic surfactant include alkylamine salts, quaternary ammonium salts, polyoxyethylene alkylamine salts, and polyethylene polyamine derivatives.

The content of the anionic surfactant is preferably largest even in the case where a nonionic surfactant or a cationic surfactant is used together with the anionic surfactant. The anionic surfactant is preferably 50% by mass or more, and more preferably 60% by mass or more, with respect to the total amount of the surfactant.

The content of the surfactant other than the anionic surfactant is preferably from 0.01% by mass to 10% by mass, and more preferably from 0.01 % by mass to 5% by mass, with respect to the total solid content of the recording layer.

### <Infrared Absorbing Agent>

The recording layer of the lithographic printing plate precursor according to the present invention contains an infrared absorbing agent. The infrared absorbing agent is not particularly limited as long as it is a dye that absorbs infrared light and generates heat, and various dyes known as infrared absorbing agents may be used.

As the infrared absorbing agent that can be used in the present invention, commercially available dyes and known dyes described in literatures, for example, Senryo Binran (Dye Handbook) compiled by The Society of Synthetic Organic Chemistry, Japan (1970) can be used. Specifically, examples of the dyes include azo dyes, metal complex azo dyes, pyrazolone azo dyes, anthraquinone dyes, phthalocyanine dyes, carbonium dyes, quinoneimine dyes, methine dyes, and cyanine dyes. In the present invention, among these dyes, those capable of absorbing at least an infrared light or a near-infrared light are preferred as suitable for use with a laser that emits an infrared light or a near-infrared light. Especially, cyanine dyes are preferable.

Among these dyes, particularly preferred examples include cyanine dyes, phthalocyanine dyes, oxonol dyes, squarylium dyes, pyrylium salts, thiopyrylium dyes, and nickel thiolate complexes. Further, the cyanine dye represented by the following formula (x) is most preferably used in the upper layer of the recording layer according to the present invention because the cyanine dye imparts polymerization activity and exhibits excellent stability and economic efficiency.

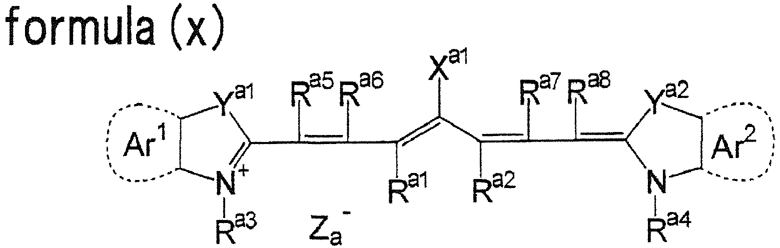

In formula (x), X^{a1} represents a hydrogen atom, a halogen atom, -NPh₂, -X^{a2}-L^{a1} or a group shown below. X² represents an oxygen atom or a sulfur atom. L^{a1} represents a hydrocarbon group having from 1 to 12 carbon atoms, an aryl group containing a hetero atom, or a hydrocarbon group having from 1 to 12 carbon atoms and containing a hetero atom. Herein, the hetero atom refers to N, S, O, a halogen atom and Se. Ph means a phenyl group.

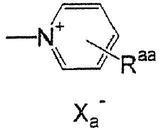

In the above formula, Xₐ⁻ has the same meaning as Zₐ⁻ defined hereinafter. R^{aa} represents a hydrogen atom or a substituent selected from an alkyl group, an aryl group, a substituted or unsubstituted amino group and a halogen atom.

R^{a1} and R^{a2} each independently represents a hydrocarbon group having from 1 to 12 carbon atoms. In view of the preservation stability of a coating solution for photosensitive layer, it is preferred that R^{a1} and R^{a2} each represent a hydrocarbon group having two or more carbon atoms. Further, R^{a1} and R^{a2} may be combined with each other to form a ring. In the case of forming a ring, it is particularly preferred to form a 5-membered or 6-membered ring.

Ar¹ and Ar², which may be the same or different, each independently represent an aromatic hydrocarbon group which may have a substituent. Preferable examples of the aromatic hydrocarbon group include a benzene ring group and a naphthalene ring group. Preferable examples of the substituent include a hydrocarbon group having 12 or less carbon atoms, a halogen atom and an alkoxy group having 12 or less carbon atoms.

Y^{a1} and Y^{a2}, which may be the same or different, each independently represent a sulfur atom or a dialkylmethylene group having 12 or less carbon atoms. R^{a3} and R^{a4}, which may be the same or different, each independently represent a hydrocarbon group having 20 or less carbon atoms, which may have a substituent. Preferable examples of the substituent include an alkoxy group having 12 or less carbon atoms, a carboxyl group and a sulfo group.

R^{a5}, R^{a6}, R^{a7} and R^{a8}, which may be the same or different, each independently represent a hydrogen atom or a hydrocarbon group having 12 or less carbon atoms. From the standpoint of the availability of raw materials, a hydrogen atom is preferred. Za⁻ represents a counter anion. However, Za⁻ is not necessary when the cyanine dye represented by formula (x) has an anionic substituent in the structure thereof and the neutralization of charge is not needed. Preferable examples of the counter ion for Za⁻ include a halide ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion in view of the preservation stability of a coating solution for photosensitive layer.

Specific examples of the cyanine dye represented by formula (x) which can be preferably used in the invention include compounds described in Paragraph Nos. [0017] to [0019] of JP-A-2001-133969, Paragraph Nos. [0012] to [0038] of JP-A-2002-40638 and Paragraph Nos. [0012] to [0023] of JP-A-2002-23360.

Particularly preferred infrared absorbing agent is cyanine dye A below.

### Cyanine dye A

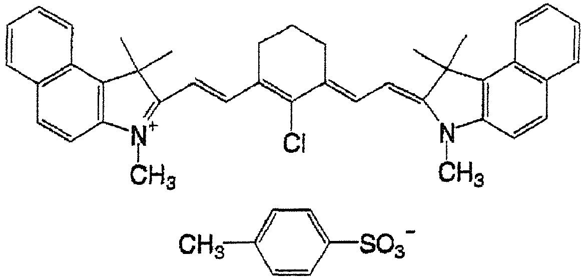

The amount of infrared absorbing agent to be is preferably 0.01 to 50% by mass relative to the total solid content of the recording layer, more preferably 0.1 to 30% by mass, and particularly preferably 1.0 to 30% by mass. If the addition amount is equal to or more than 0.01% by mass, high sensitivity is achieved. Meanwhile, if the addition amount is equal to or less than 50% by mass, a high degree of uniformity of the layer is obtained and the layer has good durability.

### <Constitution of Recording Layer>

In the present invention, the constitution of the recording layer is not particularly limited, and an embodiment of the image recording layer having multilayers composed of an upper layer and a lower layer is useful as well as another embodiment of a single layer constitution. When the above-described first to third embodiments are separately described, the above-described multilayer-image-recording layer is preferably used in the first and second embodiments. Meanwhile, a single layer- image-recording layer is preferably used in the third embodiment. The multilayer-image-recording layer of the first and second embodiments is described below as an example. The optional components used in the multilayer-image-recording layer may be also used arbitrarily in the third embodiment, if needed.

Examples of the configuration in terms of the layer constitution and components include the following combinations. Among these examples, the layer constitutions of Examples 2, 5, 6 and 7 are preferable, and the layer constitutions of Examples 2, 5 and 6 are more preferable.

**Table A**

| Example | Recording layer | Spec. AS resin | Spec. PU | Surfactant | Novolac resin | IR absorber |
|---|---|---|---|---|---|---|
| 1 | Upper layer | ○ | ○ | ○ | ○ | |
| | Lower layer | | | | | ○ |
| 2 | Upper layer | | ○ | ○ | ○ | |
| | Lower layer | ○ | | | | ○ |
| 3 | Upper layer | ○ | ○ | | ○ | |
| | Lower layer | | | ○ | | ○ |
| 4 | Upper layer | ○ | ○ | | ○ | |
| | Lower layer | | | ○ | | ○ |
| 5 | Upper layer | | ○ | ○ | | |
| | Lower layer | ○ | | | | ○ |
| 6 | Upper layer | | ○ | ○ | | |
| | Lower layer | ○ | | | ○ | ○ |
| 7 | Upper layer | | ○ | ○ | | ○ |
| | Lower layer | ○ | | | ○ | ○ |

| | | | | | | |
|---|---|---|---|---|---|---|
| Spec. AS resin: Specific Alkali Soluble or dispersible resin Spec. PU: Specific polyurethane IR absorber: Infrared Ray absorbing agent "○" means that the material is applied. | | | | | | |

### <Lower Layer>

The lower layer preferably contains the above-described infrared absorbing agent. Further, the other components may be contained as needed, as long as the effect of the present invention is not impaired. Examples of the other component include an alkali-soluble resin having a different structure from the above-described resin. Hereinafter, the alkali-soluble resin having a different structure from the above-described resin is referred to as the other alkali-soluble resin.

### (Other Alkali-soluble Resin)

In the present invention, the term "alkali-soluble" means that the resin is soluble in an alkaline solution with a pH of from 8.5 to 13.5 by a processing of a standard developing time. The resin is dissolved at a pH of more preferably from 11.0 to 13.5, still more preferably from 12.0 to 13.5, and especially preferably from 12.5 to 13.5.

The other alkali-soluble resin used in the lower layer is not limited in particular, as long as the resin has a property to be dissolved in contact with an alkaline developing solution. The resin has preferably an acidic functional group such as a phenolic hydroxyl group, a sulfonic acid group, a phosphoric acid group, a sulfonamide group, or an active imide group, at the main chain and/or side chain of the polymer. Examples of the resin include a resin containing a monomer having such an acid functional group that imparts alkali solubility, in an amount of 10% by mole or more, and more preferably 20% by mole or more as a component thereof. When the copolymerization component of the monomer that imparts alkali solubility is at least 10 mole %, sufficient alkali solubility is obtained and developability is excellent.

Furthermore, as described in U.S. Patent No. 4,123,279, a condensation polymer between formaldehyde and a phenol having as a substituent an alkyl group having 3 to 8 carbon atoms, such as a t-butylphenol formaldehyde resin or an octylphenol formaldehyde resin can be cited. The weight-average molecular weight thereof (Mw) is preferably at least 500, and more preferably 1,000 to 700,000. The number-average molecular weight thereof (Mn) is preferably at least 500, and more preferably 750 to 650,000. The dispersity (weight-average molecular weight/number-average molecular weight) is preferably 1.1 to 10.

The other alkali-soluble resin preferably has a weight-average molecular weight of at least 2,000 and a number-average molecular weight of at least 500, and more preferably a weight-average molecular weight of 5,000 to 300,000 and a number-average molecular weight of 800 to 250,000. The other alkali-soluble resin preferably has the dispersity (weight-average molecular weight/number-average molecular weight) of 1.1 to 10.

The other alkali-soluble resin which is optionally contained in the lower layer, may be used alone, or in combination of two or more thereof.

The other alkali-soluble resin may be used in an amount such that the content of the other alkali-soluble resin is from 0% by mass to 98% by mass with respect to the total solid content. The other alkali-soluble resin may be contained in a proportion of 80 parts by mass or less with respect to 100 parts by mass of the above-described particular resin.

### <Upper Layer>

The mechanisms to improve solubility with respect to an alkali-aqueous solution by heat in the upper layer are not particularly limited. Any one of the upper layers may be used, as long as the upper layer contains a binder resin whereby solubility of a heated region is improved. Examples of heat used for image formation include heat that is generated in the case where the lower layer containing an infrared absorbing agent is exposed. Examples of the upper layers in which solubility of a heated region is improved by heat include: a layer containing an alkali-soluble resin having a hydrogen bonding ability, such as novolac or urethane; a layer containing both a water-insoluble and alkali-soluble resin and a compound having a suppressive action on dissolution; and a layer containing a compound capable of causing ablation. Further in the upper layer, heat generated by adding an infrared absorbing agent to the upper layer can be used for image formation. Examples of the constitution of the upper layer containing an infrared absorbing agent include: a layer containing an infrared absorbing agent, a water-insoluble and alkali-soluble resin and a compound having a suppressive action on dissolution; and a layer containing an infrared absorbing agent, a water-insoluble and alkali-soluble resin and a compound that generates an acid by heat.

### (Water-Insoluble and Alkali-Soluble Resin)

The upper layer of the present invention preferably contains a water-insoluble and alkali-soluble resin in the upper layer. By containing the alkali-soluble resin, an interaction between the infrared absorbing agent and polar groups that the alkali-soluble resin has is formed whereby a positive-type photosensitive layer is formed. With the inclusion of the above-described exemplified resins, preferable examples of the alkali-soluble resin include polyamide resins, epoxy resins, polyacetal resins, acrylic resins, methacrylic resins, polystyrene-based resins, and novolac-type phenol resins.

The alkali-soluble resin that can be used in the present invention is not particularly limited as long as it has the property of dissolving upon contact with an alkaline developing solution, and is preferably a homopolymer containing an acidic group in the main chain and/or a side chain of the polymer, a copolymer thereof, or a mixture thereof.

Such an acidic group-containing alkali-soluble resin preferably has a functional group such as a phenolic hydroxy group, a carboxy group, a sulfonic acid group, a phosphoric acid group, a sulfonamide group, or an active imide group. Therefore, such a resin may be suitably formed by copolymerization of a monomer mixture having one or more ethylenically unsaturated monomers containing the above-mentioned functional groups. Preferred examples of the ethylenically unsaturated monomer having the above-mentioned functional group include acrylic acid, methacrylic acid, a compound represented by the formulae below, and a mixture thereof. In the formulae below, R⁴ represents a hydrogen atom or a methyl group.

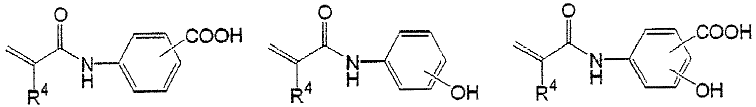

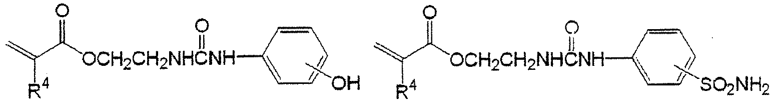

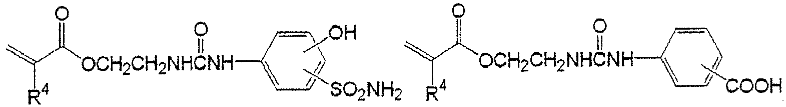

The alkali-soluble resin that can be used in the present invention is preferably a polymeric compound obtained by copolymerizing, in addition to the above-mentioned polymerizable monomer, other polymerizable monomers. With regard to the copolymerization ratio in this case, it is preferable that the copolymer contains at least 10 mole % of a monomer imparting alkali solubility such as a monomer having a functional group, e.g., a phenolic hydroxy group, a carboxy group, a sulfonic acid group, a phosphoric acid group, a sulfonamide group, or an active imide group, and it is more preferable that the copolymer contains at least 20 mole % of the above monomer. When the copolymerization component of the monomer that imparts alkali solubility is at least 10 mole %, sufficient alkali solubility is obtained and developability is excellent.

Examples of the other usable polymerizable monomers include the following compounds: alkyl acrylates and alkyl methacrylates, such as methyl acrylate, ethyl acrylate, propyl acrylate, benzyl acrylate, methyl methacrylate, ethyl methacrylate, cyclohexyl methacrylate, and benzyl methacrylate; acrylates and methacrylates having an aliphatic hydroxyl group, such as 2-hydroxyethyl acrylate and 2-hydroxyethyl methacrylate; acrylamides and methacrylamides, such as acrylamide, methacrylamide, N-methylacrylamide, N-ethyl acrylamide, and N-phenyl acrylamide; vinyl esters such as vinyl acetate, vinyl chloroacetate, vinyl butylate, and vinyl benzoate; styrenes such as styrene, α-methylstyrene, methylstyrene, and chloromethylstyrene; other nitrogen atom-containing monomers such as N-vinylpyrrolidone, N-vinylpyridine, acrylonitrile, and methacrylonitrile; and maleimides such as N-methylmaleimide, N-ethylmaleimide, N-propyl maleimide, N-butyl maleimide, N-phenyl maleimide, N-2-methylphenyl maleimide, N-2,6-diethylphenyl maleimide, N-2-chlorophenyl maleimide, N-cyclohexyl maleimide, N-lauryl maleimide, and N-hydroxyphenyl maleimide.

Among these other ethylenically unsaturated monomers, (meth)acrylates, (meth)acrylamides, maleimides, and (meth)acrylonitrile are preferred.

Furthermore, as the alkali-soluble resin, a novolac resin can be preferably exemplified as stated above.

The water-insoluble and alkali-soluble resin preferably has a weight average molecular weight of 2,000 or more, and a number average molecular weight of 500 or more, and more preferably has a weight average molecular weight of from 5,000 to 300,000, a number average molecular weight of from 800 to 250,000, and a dispersivity (weight average molecular weight/number average molecular weight) of from 1.1 to 10.

The alkali-soluble resin contained in the upper layer of the image recording material according to the present invention may be used alone, or in combination of two or more thereof.

The content of the alkali-soluble resin with respect to the total solid content of the upper layer in the present invention is preferably from 2.0% by mass to 99.5% by mass, more preferably from 10.0% by mass to 99.0% by mass, and still more preferably from 20.0% by mass to 90.0% by mass. If the content is 2.0% by mass or more, good durability of the recording layer (photosensitive layer) is achieved. Meanwhile, if the content is 99.5% by mass or less, the recording layer has high sensitivity as well as good durability.

### (Acid-Generating Agent)

The upper layer of the image recording layer preferably contains an acid-generating agent from the viewpoint of improvement in sensitivity.

In the present invention, the acid-generating agent refers to a compound that generates an acid by light or heat, and the compound that decomposes by irradiation of infrared, or heating at 100°C or higher to generate an acid. The generated acid is preferably a strong acid with pKa of 2 or less, such as sulfonic acid or hydrochloric acid. The acid generated from the acid-generating agent acts as a catalyst whereby the chemical bond of an acid-degradable group is cleaved to become an acid group by which solubility of the upper layer with respect to an alkali aqueous solution is improved.

The acid-generating agent which is preferably used in the invention includes an onium salt, for example, an iodonium salt, a sulfonium salt, a phosphonium salt or a diazonium salt. Specific examples thereof include compounds described, for example, in U.S. Patent No. 4,708,925 and JP-A-7-20629. In particular, an iodonium salt, a sulfonium salt and a diazonium salt each of which has a sulfonate ion as a counter ion are preferable. As the diazonium salt, diazonium compounds described in U.S. Patent No. 3,867,147, diazonium compounds described in U.S. Patent No. 2,632,703, and diazonium resins described in JP-A-1-102456 and JP-A-1-102457 are also preferable. Further, benzylsulfonates described in U.S. Patent No. 5,135,838 and U.S. Patent No. 5,200,544 are also preferable. Moreover, active sulfonic acid ester and disulfonyl compounds described in JP-A-2-100054, JP-A-2-100055 and Japanese Patent Application No. 8-9444 (JP-A-9-197671) are also preferable. In addition, haloalkyl-substituted s-triazine compounds described in JP-A-7-271029 are also preferable.

The compounds described as "an acid precursor" in JP-A-8-220752, or the compounds described as "(a) a compound capable of generating an acid by irradiation of activated light rays" in JP-A-9-171254 and the like may be suitably used also as an acid-generating agent in the present invention.

Especially from the viewpoint of sensitivity and stability, an onium salt compound is preferably used as the acid-generating agent. The onium salt compound is described below.

As for the onium salt compound that may be favorably used in the present invention, compounds which are known as a compound that decomposes by infrared exposure and a heat energy that generates from an infrared absorbing agent by the exposure thereby generating an acid may be exemplified. As for the onium salt compound that may be favorably used in the present invention, from the viewpoint of sensitivity, known thermal polymerization initiators and compounds having the following onium salt structure having a bond that is small in terms of bond dissociation energy may be exemplified.

Examples of the onium salt that may be favorably used in the present invention include diazonium salts, iodonium salts, sulfonium salts, ammonium salts, pyridinium salts, and azinium salts, all of which are known. Especially, salts such as sulfonate, carbonate, BF⁴⁻, PF⁶⁻, or CLO⁴⁻ of triaryl sulfonium, or diaryl iodonium are preferable.

Specific examples of the azinium salt compounds include compounds described in paragraph Nos. [0047] to [0056] of JP-A-2008-195018. Further, compounds having an N-O bond, described in JP-A-63-138345, JP-A-63-142345, JP-A-63-142346, JP-A-63-143537 and JP-B-46-42363 ("JP-B" means an examined publication of Japanese patent application) are also favorably used as an acid-generating agent in the present invention.

A preferable addition amount of the acid-generating agent, in the case where the acid-generating agent is added to an upper layer, is in a range of from 0.01% by mass to 50% by mass, more preferably from 0.1% by mass to 40% by mass, and still more preferably from 0.5% by mass to 30% by mass, with respect to the total solid content of the upper layer. In the above-described range, improvement of sensitivity that is an effect due to the addition of the acid-generating agent is achieved and generation of a residual film in the non-image area is suppressed at the same time.

### (Acid Proliferator)

An acid proliferator may be added to the upper layer in the present invention.

The acid proliferator in the present invention refers to a compound substituted with a residue of a relatively strong acid and the compound that is easily eliminates in the presence of an acid catalyst to generate a new acid. That is, the acid proliferator decomposes by an acid-catalyzed reaction to generate again an acid (hereinafter referred to as ZOH in formula). One or more acids increase per one reaction whereby an acid concentration increases in an accelerated rate in accordance with a progress of the reaction, which results in tremendously improved sensitivity. The strength of the generated acid is preferably 3 or less, and more preferably 2 or less in terms of acid dissociation constant (pKa). If the pKa of the generated acid is smaller than these values, elimination reaction due to an acid catalyst cannot be caused.

Examples of the acid used for such acid catalyst include dichloroacetic acid, trichloroacetic acid, methane sulfonic acid, ethane sulfonic acid, benzene sulfonic acid, p-toluene sulfonic acid, and naphthalene sulfonic acid.

The acid proliferators described in WO 95/29968, WO 98/24000, JP-A-8-305262, JP-A-9-34106, JP-A-8-248561, JP-T-8-503082, U.S. Patent No. 5,445,917, JP-T-8-503081, U.S. Patent No. 5,534,393, U.S. Patent No. 5,395,736, U.S. Patent No. 5,741,630, U.S. Patent No. 5,334,489, U.S. Patent No. 5,582,956, U.S. Patent No. 5,578,424, U.S. Patent No. 5,453,345, U.S. Patent No. 5,445,917, EP 665,960, EP 757,628, EP 665,961, U.S. Patent No. 5,667,943, JP-A-10-1598, and the like may be used alone, or in combination of two or more thereof.

The addition amount of the acid proliferator, in the case where the acid proliferator is added to an upper layer, is generally in a range of from 0.01% by mass to 20% by mass, preferably from 0.01% by mass to 10% by mass, and more preferably from 0.1% by mass to 5% by mass, with respect to the total solid content of the upper layer. If the addition amount of the acid proliferator is in the above-described range, a sufficient effect of adding the acid proliferator is obtained whereby improvement in sensitivity is achieved and reduction of film strength in the image area is suppressed at the same time. As a result, good film strength due to the particular resin is kept.

### (Other Additives)

When forming the lower layer and the upper layer, in addition to the above essential components, various additives may be added as necessary as long as the effects of the present invention are not impaired. The additives cited below may be added only to the lower layer, only to the upper layer, or to both layers.

### (Development Accelerator)

For the purpose of improving the sensitivity, acid anhydrides, phenols, or organic acids may be added to the upper layer and/or the lower layer.

The acid anhydride is preferably a cyclic acid anhydride, and specific examples of the cyclic acid anhydride include phthalic anhydride, tetrahydrophthalic anhydride, hexahydrophthalic anhydride, 3,6-endooxytetrahydrophthalic anhydride, tetrachlorophthalic anhydride, maleic anhydride, chloromaleic anhydride, α-phenylmaleic anhydride, succinic anhydride, and pyromellitic anhydride described in U.S. Patent No. 4,115,128. As an acyclic acid anhydride, acetic anhydride, etc. can be cited.

Examples of the phenols include bisphenol A, 2,2'-bishydroxysulfone, p-nitrophenol, p-ethoxyphenol, 2,4,4'-trihydroxybenzophenone, 2,3,4-trihydroxybenzophenone, 4-hydroxybenzophenone, 4,4',4"-trihydroxytriphenylmethane, 4,4',3",4"-tetrahydroxy-3,5,3',5'-tetramethyltriphenylmethane, etc.

As the organic acids, there are those described in JP-A-60-88942, JP-A-2-96755, etc., and specific examples thereof include p-toluenesulfonic acid, dodecylbenzenesulfonic acid, p-toluenesulfmic acid, ethylsulfuric acid, phenylphosphonic acid, phenylphosphinic acid, phenyl phosphate, diphenyl phosphate, benzoic acid, isophthalic acid, adipic acid, p-toluic acid, 3,4-dimethoxybenzoic acid, phthalic acid, terephthalic acid, 4-cyclohexene-1,2-dicarboxylic acid, erucic acid, lauric acid, n-undecanoic acid, and ascorbic acid.

The ratio of each of the acid anhydrides, phenols, and organic acids relative to the total solid content of the lower layer or the upper layer is preferably 0.05 to 20% by mass, more preferably 0.1 to 15% by mass, and particularly preferably 0.1 to 10% by mass.

### (Other Surfactant)

For the purpose of improving the coating properties, the upper layer and/or the lower layer may contain a copolymer of a fluorine-containing monomer described in JP-A-62-170950, JP-A-11-288093, and JP-A-2003-057820, in addition to the above-described surfactants.

The ratio of the other surfactant relative to the total solid content of the layer containing the other surfactant is preferably 0.01 to 15% by mass, more preferably 0.01 to 5% by mass, and yet more preferably 0.05 to 2.0% by mass.

### (Printing-Out Agent/Colorant)

The upper layer and/or the lower layer may contain a dye or a pigment as a printing-out agent or an image colorant to immediately form a visible image after the heating caused by exposure.

Details of the printing-out agent and the colorant are described in paragraph Nos. [0122] to [0123] of JP-A-2009-229917. Accordingly, these compounds described therein may be also suitably used in the present invention.

These dyes are preferably added at a ratio of 0.01 to 10% by mass relative to the total solid content of the lower layer or the upper layer, and more preferably at a ratio of 0.1 to 3% by mass.

### (Plasticizer)

A plasticizer may be added to the upper layer and/or the lower layer in order to impart flexibility, etc. to the coating. Examples thereof include butylphthalyl, polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl oleate, and oligomers and polymers of acrylic acid or methacrylic acid.

These plasticizers are preferably added at a ratio of 0.5 to 10% by mass relative to the total solid content of the lower layer or the upper layer, and more preferably at a ratio of 1.0 to 5% by mass.

### (Wax)

For the purpose of imparting resistance to scratching, a compound that reduces the coefficient of static friction of the surface may be added to the upper layer. Specific examples thereof include compounds containing esters of long chain alkylcarboxylic acids, such as those described in U.S. Patent No. 6,117,913, JP-A-2003-149799, JP-A-2003-302750, or JP-A-2004-12770.

The amount thereof added as a proportion in the upper layer is preferably 0.1 to 10% by mass, and more preferably 0.5 to 5% by mass.

### <Formation of Lower Layer and Upper Layer>

The lower layer and the upper layer of the lithographic printing plate precursor of the present invention may usually be formed by dissolving the above-mentioned components in a solvent and coating an appropriate support therewith.

Examples of the solvent used here include ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxy ethane, methyl lactate, ethyl lactate, N,N-dimethylacetamide, N,N-dimethylformamide, tetramethylurea, N-methylpyrrolidone, dimethyl sulfoxide, sulfolane, γ-butyrolactone, or toluene. However, the present invention is not limited to these solvents. These solvents may be used alone, or in combination of two or more thereof.

The lower layer and the upper layer are in principle preferably formed as two separate layers.

Examples of a method for forming two separate layers include a method in which a difference in solvent solubility between components contained in the lower layer and components contained in the upper layer is utilized.

Examples of another method for forming two separate layers include a method in which, after an upper layer is applied, the solvent is rapidly removed by drying. Separation between these layers is performed more favorably by combining these methods.

These methods are described in detail below, but the method for coating as two separate layers is not limited to these methods.

As the method in which a difference in solvent solubility between the components contained in the lower layer and the components contained in the upper layer is utilized, a solvent system in which all of the components contained in the lower layer are insoluble is used when applying an upper layer coating solution. This enables each layer to be formed in a clearly separated manner even when carrying out two-layer coating. For example, making two layers is possible by selecting as a lower layer component a component that is insoluble in a solvent, such as methyl ethyl ketone or 1-methoxy-2-propanol, that dissolves an alkali-soluble resin, which is an upper layer component, coating and drying the lower layer using a solvent system that dissolves the lower layer component, and subsequently dissolving an upper layer mainly containing an alkali-soluble resin in methyl ethyl ketone, 1-methoxy-2-propanol, etc., followed by coating and drying.

The method for very rapidly drying the solvent after a second layer (upper layer) is applied may be achieved by blowing high-pressure air via a slit nozzle placed at substantially right angles relative to the web traveling direction, applying thermal energy as conductive heat from a lower face of a web using a roll having a heating medium such as steam supplied to the interior thereof (heating roll), or combining the above.

The amount of coating after drying of the lower layer component applied onto the support of the lithographic printing plate precursor is preferably in the range of 0.5 to 4.0 g/m², and more preferably in the range of 0.6 to 2.5 g/m². When it is at least 0.5 g/m², the printing durability is excellent, and when it is no greater than 4.0 g/m², the image reproduction and sensitivity are excellent.

The amount of coating after drying of the upper layer component is preferably in the range of 0.05 to 1.0 g/m², and more preferably in the range of 0.08 to 0.7 g/m². When it is at least 0.05 g/m², the development latitude and scratch resistance are excellent, and when it is no greater than 1.0 g/m², the sensitivity is excellent.

The amount of coating after drying of the lower layer and the upper layer in total is preferably in the range of 0.6 to 4.0 g/m², and more preferably in the range of 0.7 to 2.5 g/m². When it is at least 0.6 g/m², the printing durability is excellent, and when it is no greater than 4.0 g/m², the image reproduction and the sensitivity are excellent.

### <Support>

As the support used in the lithographic printing plate precursor of the present invention, a polyester film and an aluminum plate are preferable. Among them, aluminum plates are particularly preferred owing to their good dimensional stability and relatively low cost. Preferred aluminum plates are pure aluminum plates and aluminum alloy plates composed mainly of aluminum and containing a trace amount of different elements. It may be plastic films on which aluminum has been laminated or deposited. Examples of the different elements contained in the aluminum alloys include silicon, iron, manganese, copper, magnesium, chromium, zinc, bismuth, nickel, and titanium. The content of the different elements in total in an alloy is preferably 10% by mass or less.

A particularly desirable aluminum in the present invention is pure aluminum, but since it is difficult to produce completely pure aluminum in terms of refining techniques, it may contain a trace amount of other elements.

Such an aluminum plate applied to the present invention is not specified in terms of composition, and an aluminum plate formed from a conventionally known, widely used material may appropriately be used. The thickness of the aluminum plate used in the present invention is preferably 0.1 to 0.6 mm, more preferably 0.15 to 0.4 mm, and particularly preferably 0.2 to 0.3 mm.

The aluminum plate may be subjected to various kinds of surface treatments such as a roughening treatment or an anodic oxidation treatment, if needed. For the surface treatment of the aluminum plate, treatments may be carried out appropriately, such as a degreasing treatment with a surfactant, an organic solvent, an alkaline aqueous solution, or the like, a roughening treatment on the surface, or an anodic oxidation treatment, as described in detail in paragraph Nos. [0167] to [0169] of JP-A-2009-175195.

After the anodic oxidation treatment, the surface of the aluminum plate is subjected to, as necessary, a hydrophilizing treatment.

Examples of the hydrophilizing treatment to be used include an alkali metal silicate method (for example, sodium silicate aqueous solution) and a method of treating with potassium fluorozirconate or polyvinyl sulfonic acid, as described in paragraph No. [0169] of JP-A-2009-175195.

### <Undercoat Layer>

In the present invention, an undercoat layer may be disposed, as necessary, between the support and the lower layer.

As the components of the undercoat layer, various organic compounds may be used. Preferable examples of the organic compounds include: carboxymethyl cellulose; dextrin; amino group-containing phosphonic acids; organic phosphonic acids; organic phosphoric acids; an organic phosphinic acid; amino acids; and hydroxyl group-containing amine hydrochlorides. With regard to these undercoat layer components, one type may be used on its own or two or more types may be used as a mixture. Details of the compound used in the undercoat layer and a method of forming the undercoat layer are described in paragraph Nos. [0171] to [0172] of JP-A-2009-175195. These disclosures are also used suitably in the present invention.

The amount of coating of the organic undercoat layer is preferably 2 to 200 mg/m², and more preferably 5 to 100 mg/m². When the amount of coating is in the above-mentioned range, sufficient printing durabiliy can be obtained.

### <Backcoat Layer>

The reverse face of the support of the lithographic printing plate precursor of the present invention is provided with a backcoat layer as necessary. As such a backcoat layer, a coating layer comprising an organic polymeric compound described in JP-A-5-45885 or a coating layer comprising a metal oxide obtained by hydrolysis and polycondensation of an organic or inorganic metal compound described in JP-A-6-35174 is preferably used. Among these coating layers, use of alkoxy compounds of silicon such as Si(OCH₃)₄, Si(OC₂H₅)₄, Si(OC₃H₇)₄, or Si(OC₄H₉)₄ is particularly preferable since these materials are inexpensive and readily available and the metal oxide coating layer obtained therefrom has excellent developing solution resistance.

The lithographic printing plate precursor prepared as described above is image-wise exposed, and then subjected to a development processing.

### <Method for Making Lithographic Printing Plate>

A method for making a lithographic printing plate according to the invention includes: an exposure step of performing image-wise exposure to infrared of the above-described infrared-sensitive positive-type lithographic printing plate precursor of the present invention; and a development step of developing the exposed lithographic printing plate precursor using an alkaline aqueous solution with a pH of from 11.0 to 13.5 (preferably from 12.0 to 13.5, and more preferably from 12.5 to 13.5), in this order.

According to the method for making a lithographic printing plate according to the invention, the stability after exposure is improved. As a result, the obtained lithographic printing plate has high strength of the image area and excellent durability without generation of stain caused by the residual film in the non-image area.

Each step of the plate making is described in detail below.

### <Exposure Step>

The process for making a lithographic printing plate of the present invention contains an exposure step of imagewise exposing the positive type lithographic printing plate precursor for infrared.

The actinic radiation light source used for imagewise exposure of the lithographic printing plate precursor of the invention is preferably a light source having an emission wavelength in the near-infrared to infrared region, and is more preferably a solid-state laser or a semiconductor laser. Among them, in the present invention, it is particularly preferable to carry out imagewise exposure using a solid-state laser or semiconductor laser that emits infrared radiation having a wavelength of 750 to 1,400 nm.

The laser output is preferably at least 100 mW, and in order to shorten the exposure time it is preferable to use a multi-beam laser device. It is also preferable that the exposure time per pixel is within 20 µseconds.

The energy with which a lithographic printing plate precursor is irradiated is preferably 10 to 300 mJ/cm². When the energy is in this range, curing progresses sufficiently, laser ablation can be suppressed, and damage to an image can be prevented.

Exposure in the present invention may be carried out by making light beams of the light source overlap. Overlap means that the sub-scanning pitch width is smaller than the beam diameter. When the beam diameter is expressed as a full width half maximum (FWHM) of the beam intensity, the overlap may be expressed quantitatively using, for example, FWHM/sub-scanning pitch width (overlap factor). In the present invention, this overlap factor is preferably at least 0.1.

The scanning method of the light source of exposure equipment that can be used in the present invention is not particularly limited, and a cylinder outer face scanning method, a cylinder inner face scanning method, a flat face scanning method, etc. may be used. The light source channel may be single channel or multi channel, but in the case of the cylinder outer face method, multi channel is preferably used.

### <Development Step>

### Developing Solution

The method for making a lithographic printing plate according to the invention includes a development step of developing the lithographic printing plate precursor using an alkaline aqueous solution. The alkaline aqueous solution (hereinafter, also referred to as "a developing solution") used in the development step is an alkaline aqueous solution having a pH of from 11.0 to 13.5 (preferably from 12.0 to 13.5, and more preferably from 12.5 to 13.5). Herein, the pH is defined as the value obtained by measurement at room temperature (20°C) using F-51 (trade name) manufactured by HORIBA, Ltd.

In the present invention, even in the case where a developing solution having a high pH is used, highly stabilized processing can be realized because the above-described particular surfactant is incorporated in a photosensitive layer in combination with the particular resin.

To be specific, an automatic processor (automatic developing machine) controls the alkali concentration in terms of conductivity. If the alkali concentration is maintained constant, the concentration of the surfactant necessary for development of the binder in the recording layer is increased or decreased by little and little. That is, this developing solution lacks stability of the processing.

In contrast, the present invention has the advantage that since the surfactant has preliminarily incorporated in the image recording layer of the lithographic printing plate precursor, the concentration of the surfactant is maintained constant from the initial period, even though the developing solution is controlled only by the alkali concentration.

Examples of the component that makes the developing solution alkaline include lithium, sodium, and potassium. Sodium is especially preferable. Carbonates of these components may be used. These components may be used singly, or in combination of two kinds or more.

Further, the developing solution preferably contains a surfactant, and more preferably contains at least an anionic surfactant or an amphoteric surfactant. The surfactant contributes to improving processability. The surfactant is preferably identical to the surfactant contained in the image recording layer of the lithographic printing plate precursor. This combination makes it possible to allow the surfactant in the image recording layer and the surfactant in the developing solution to interact with each other, thereby contributing to realization of further favorable developability and stability.

As for the surfactant used in the developing solution, any one of anionic surfactants, nonionic surfactants, cationic surfactants, and amphoteric surfactants may be used. As already described above, anionic surfactants or amphoteric (betaine-type) surfactants are preferable.

The anionic surfactant for use in the developing solution is not particularly limited and includes, for example, fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkyldiphenylether (di)sulfonic acid salts, alkylphenoxy polyoxyethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, alkylbenzenesulfonic acid salts, alkylnaphthalenesulfonic acid salts and alkyldiphenylether (di)sulfonic acid salts are particularly preferably used.

The nonionic surfactant for use in the developing solution is not particularly limited and includes, for example, polyethylene glycol type higher alcohol ethylene oxide adducts, alkylphenol ethylene oxide adducts, alkylnaphthol ethylene oxide adducts, phenol ethylene oxide adducts, naphthol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, ethylene oxide adducts of fat, polypropylene glycol ethylene oxide adducts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines. Of the compounds, those having an aromatic ring and an ethylene oxide chain are preferred, and alkyl-substituted or unsubstituted phenol ethylene oxide adducts and alkyl-substituted or unsubstituted naphthol ethylene oxide adducts are more preferred.

The amphoteric surfactant for use in the developing solution is not particularly limited and includes, for example, alkyldi(aminoethyl)glycine, alkylpolyaminoethyl glycine hydrochloride, 2-alkyl-N-carboxyethyl-N-hydroxyethyl imidazolinium betaine, and N-tetradecyl-N,N-betaine.

As for the surfactant used in the developing solution, anionic surfactants and amphoteric surfactants are preferable. Anionic surfactants containing a sulfonic acid or salt thereof are especially preferable.

Two or more kinds of the surfactant may be used in combination.

The content of the surfactant in the developing solution is preferably from 0.01 to 10 mass%, and more preferably from 0.01 to 5 mass%.

In order to maintain the pH of the developing solution in the favorable range, a carbonate ion and a bicarbonate ion are preferably present as buffers in the developing solution. This is likely due to that the carbonate and bicarbonate ions control the variation of the pH during long-time use of the developing solution, and thus prevent the deterioration of developability and the generation of developing residues caused by pH variation. In order to establish the presence of the carbonate and bicarbonate ions in the developing solution, a carbonate and a bicarbonate (or hydrogen carbonate) may be added to the developing solution, or the pH may be adjusted after the addition of a carbonate or bicarbonate, to generate carbonate and bicarbonate ions. The carbonate and bicarbonate are not particularly limited, but are preferably alkali metal salts. Examples of the alkali metal include lithium, sodium, and potassium. Among them, sodium is particularly preferred. They may be used alone, or in combination of two or more thereof.

The total amount of the carbonate and bicarbonate is preferably from 0.3 to 20% by mass, more preferably from 0.5 to 10% by mass, and particularly preferably from 1 to 5% by mass, with respect to the total mass of the developing solution. When the total amount is 0.3% by mass or more, the developability and processing ability do not deteriorate, and when the total amount is 20% by mass or less, precipitates or crystals are hardly formed, and gelation hardly occurs during neutralization for the treatment of the waste developing solution, so that the treatment is carried out smoothly.

The developing solution may each contain, in addition to the above-described components, other components such as an organic alkaline agent, a humectant, an antiseptic, a chelate compound, an anti-foaming agent, an organic acid, an organic solvent, a polar solvent, an inorganic acid, or an inorganic salt.

### (Development Treatment)

The development temperature is not particularly limited as long as development is possible, but is preferably no higher than 60°C, and more preferably 15°C to 40°C. In development processing using an automatic processor, since the developing solution might be exhausted depending on the amount processed, the processing performance may be recovered by use of a replenisher or fresh developing solution. As one example of development and post-development treatments, there is a method in which alkali development is carried out, the alkali is removed by a water washing post-step, a gumming treatment is carried out in a gumming step, and drying is carried out in a drying step. As another example, a method in which a water washing pre-step, a development step, and a gumming step are carried out at the same time using an aqueous solution containing carbonate ions, bicarbonate ions, and a surfactant can be cited as a preferred example. It is therefore preferable to carry out a drying step after carrying out a water washing pre-step, a development step, and a gumming step by the use of one solution and, furthermore, with one bath, without particularly carrying out a water washing pre-step. It is preferable to carry out drying subsequent to removal of extra developing solution using a squeegee roller, etc. after development.

It is more preferred that the development step be carried out using an automatic processor equipped with a rubbing member. Examples of the automatic processor include automatic processors as disclosed in JP-A-2-220061 and JP-A-60-59351, in which a lithographic printing plate precursor after image-wise exposure is subjected to rubbing treatment while being transferred, and automatic processors as disclosed in U.S. Patent No. 5,148,746, U.S. Patent No. 5,568,768, and U.K. Patent No. 2297719, in which a lithographic printing plate precursor after image-wise exposure is mounted on a cylinder, and subjected to rubbing treatment while the cylinder is rotated. Among them, an automatic processor having a rotary brush roll as a rubbing member is particularly preferred.

It is preferred that a continuous or discontinuous drying step be performed after the development step. The drying is carried out using, for example, hot air, infrared radiation, or far infrared rays.

As for the automatic processor favorably used in the method for making the lithographic printing plate according to the present invention, an apparatus equipped with a development unit and drying unit is used. The lithographic printing plate precursor was subjected to development and gumming treatment in a developing solution tank, and then dried in the drying unit to obtain a lithographic printing plate.

Furthermore, for the purpose of improving printing durability, etc., the printing plate after development may be heated under very severe conditions. The heating temperature may be usually from 200°C to 500°C. When the temperature is low, sufficient image enhancement effect is not achieved, and when the temperature is too high, problems such as the deterioration of the support and pyrolysis of the image areas may occur.

The lithographic printing plate obtained in this manner is mounted on an offset printing machine, and used for printing a lot of sheets.

The lithographic printing plate precursor of the present invention realizes both high plate durability and high chemical resistance in the lithographic printing and also achieves good developability in the exposed area, suppression of a running residual, and a good concentration performance of a developing waste liquid at the same time. Further, the preparation method of the present invention makes it possible to produce the lithographic printing plate precursor that exhibits the above-described excellent performances.

### EXAMPLES

The present invention will be described in more detail based on examples given below, but the invention is not meant to be limited by these.

### (Example I)

### [Synthesis Example 1-1]

Into a 500 ml three-necked round-bottom flask equipped with a condenser and a stirrer, 2.7 g of 4,4'-diphenylmethane diisocyanate, 14.5 g of toluene-2,4- diisocyanate, 7.0 g of neopentyl glycol, 35.8 g of 2,2-bis (hydroxymethyl) propionic acid and 280 g of 3-pentanone were introduced. Further, 0.3 g of dibutyl tin didodecanoate was added, and then the temperature of the resultant reaction mixture was elevated to 80°C by heating while stirring. The reaction was continued at 80°C for 6 hours. Thus, Polyurethane (1) was obtained. The weight-average molecular weight measured by GPC was 24,000. The acid value was 125.

### [Synthesis Examples 1-2 to 1-9]

Polyurethanes (2) to (9) were synthesized in the same manner as in Synthesis Example I-1, except that the diisocyanate compounds and the diol compounds were replaced with the diisocyanate compounds and the diol compounds shown in Table I-1 and the following formulae.

**Table I-1**

| Polyurethane | Diisocyanate compound | | | | Diol compound | | | | DI:DO | Mw* |
|---|---|---|---|---|---|---|---|---|---|---|
| | # | mole % | # | mole % | # | mole % | # | mole % | | |
| (2) | DI-1 | - | - | - | DO-1 | - | - | - | 1.5:1 | 7,000 |
| (3) | DI-1 | - | - | - | DO-1 | - | - | - | 1:1.2 | 12,000 |
| (4) | DI-2 | 75 | DI-3 | 25 | DO-1 | - | - | - | 1:1.1 | 17,000 |
| (5) | DI-1 | 80 | DI-3 | 20 | DO-3 | - | - | - | 1:1 | 23,000 |
| (6) | DI-1 | 75 | DI-3 | 25 | DO-1 | 75 | DO-4 | 25 | 1:1 | 25,000 |
| (7) | DI-1 | - | - | - | DO-1 | 85 | DO-2 | 15 | 1:1.05 | 20,000 |
| (8) | DI-1 | 75 | DI-4 | 25 | DO-1 | - | - | - | 1:1.05 | 19,000 |
| (9) | DI-1 | 80 | DI-3 | 20 | DO-1 | 85 | DO-5 | 15 | 1:1.1 | 18,000 |

| | | | | | | | | | | |
|---|---|---|---|---|---|---|---|---|---|---|
| * Mw: Molecular weight (weight average) | | | | | | | | | | |

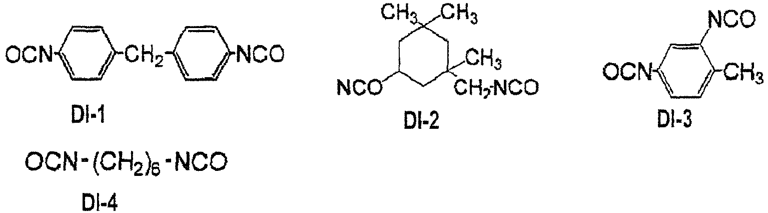

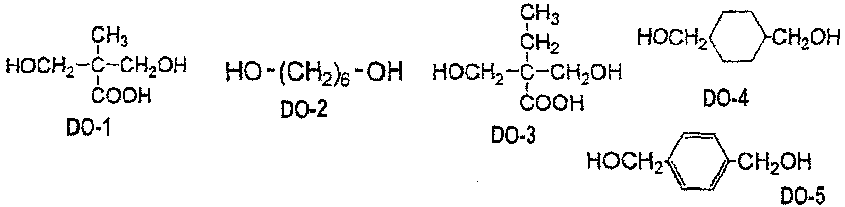

### [Example I-1 and Comparative Example I-1]

### <Preparation of Support>

The surface of a JIS A 1050 aluminum plate having a thickness of 0.3 mm was subjected to graining by means of a rotating nylon brush using a pumice-water suspension as an abrasive. Here, the surface roughness (center line average roughness) was 0.5 µm. After washing with water, the plate was immersed in a 10% sodium hydroxide aqueous solution, that had been heated to 70°C, and subjected to etching so that the amount of aluminum dissolved was 6 g/m³. After washing with water, the plate was immersed in a 30% nitric acid aqueous solution for 1 minute, so as to carry out neutralization, and washed well with water. Subsequently, it was subjected to electrolytic roughening for 20 seconds in a 0.7% nitric acid aqueous solution using a rectangular alternating waveform voltage with a voltage of 13 V for the anode and a voltage of 6 V for the cathode, immersed in a 20% sulfuric acid solution at 50°C, so as to wash the surface, and then washed with water. The roughened aluminum plate was subjected to formation of a porous anodized film using direct current in a 20% sulfuric acid aqueous solution. Electrolysis was carried out at an electric current density of 5 A/dm², and a substrate having on the surface an anodized film with a weight of 4.0 g/m² was formed by controlling the electrolysis time. This substrate was treated for 10 seconds in a vapor chamber that had been saturated at 100°C and 1 atm, thus giving a substrate (b) with a sealing ratio of 60%. The substrate (b) was subjected to a surface hydrophilization treatment using a 2.5% by mass aqueous solution of sodium silicate at 30°C for 10 seconds and then coated with undercoat solution 1 described below, and the coating film was dried at 80°C for 15 seconds, thus giving a lithographic printing plate support [B]. The amount of coating after drying was 15 mg/m².

### <Preparation of Undercoat Intermediate Layer>

The following coating solution for forming an intermediate layer was coated on the support [B] prepared as described above, and then dried at 80°C for 15 seconds to provide an intermediate layer. The amount of coating after drying was 15 mg/m².

### (Undercoat Solution 1)

The following Copolymer having

| | |
|---|---|
| a weight-average molecular weight of 28,000 | 0.5 g |
| Methanol | 100 g |
| Water | 1 g |

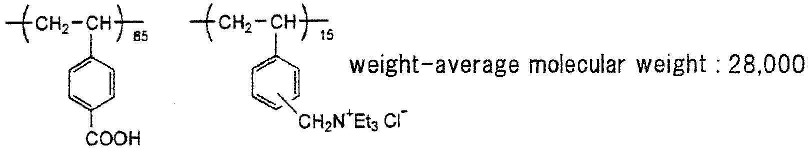

### <Formation of Recording Layer>

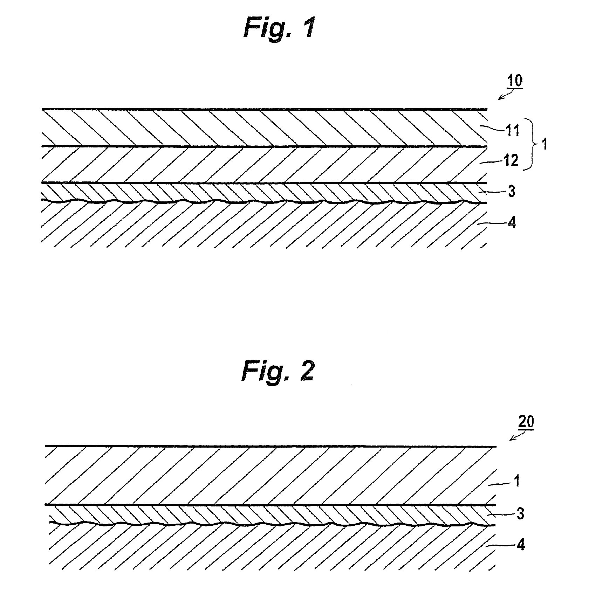

The undercoated support [B] thus obtained was provided with a lower layer by coating it with the photosensitive solution L1 for lower layer having the following composition using a wire bar and drying in a drying oven at 150°C for 40 seconds, so as to give a coating amount of 1.3 g/m². After the lower layer was provided, an upper layer was provided by coating with the photosensitive solution U1 for upper layer having the following composition using a wire bar. After coating, drying was carried out at 150°C for 40 seconds, thus giving a photosensitive lithographic printing plate precursor for infrared laser having the total coating amount for the lower layer and the upper layer of 1.7 g/m². This lithographic printing plate precursor has the multilayer structure as shown in Fig. 1.

### (Photosensitive Solution L1 for Lower layer) None ofNVK (novolac) Resin N-Phenylmaleimide/Methacrylic Acid/Methacrylamide copolymer

| | |
|---|---|
| (mass ratio: 59/15/25, Mw: 50,000) | 5.21 g |
| Infrared absorbing agent (The above-described cyanine dye A) | 0.94 g |
| Crystal Violet (manufactured by Hodogaya Chemical Co., Ltd) | 0.08 g |
| Methyl ethyl ketone | 61.00 g |
| Propylene glycol monomethyl ether | 14.00 g |
| γ-Butyrolactone | 9.40 g |
| Water | 0.03 g |
| (Photosensitive Solution U1 for Upper Layer) None of IR Dye/none of NVK Resin Polyurethane (1) (25%, 3-pentanone solution) | 30.00 g |
| Ethyl Violet | 0.03 g |
| Surfactant described in Table 1-2 | Content described in |
| | Table I-2 (mass%) |
| Fluorine-based surfactant (trade name: Megafac F-176, manufactured by DIC Corporation) | 0.05 g |
| 3-Pentanone | 62.40 g |
| Propylene glycol monomethylether-2-acetate | 7.37 g |

The thus-obtained lithographic printing plate precursor was subjected to the following evaluation. The results are shown in Table I-2.

### <Evaluation of Running Residue>

40 m S/cm of initial conductivity and 45 m S/cm of equilibrium conductivity of a developing solution were input into a control section of an automatic processor.

The above-described plate for running was processed at a rate of average 50 prints per day for 1 month using the automatic processor. During this time, exposure was conducted in a manner such that the plate was overall exposed under the conditions of beam intensity of 9 w and drum rotation speed of 150 rpm using TRENDSETTER (trade name) manufactured by Creo Products Inc.

One month after the beginning of processing, a developing solution was removed from a developing solution tank, and the situation in the developing solution tank was examined by visual observation. As a result, no residue was found.

The criterion for the evaluation of running residue is as follows:
AA: The situation in which no or almost no developing residue is found by visual observation after the developing solution was removed from the developing solution tank.
B: The level at which a developing residue is easily found by visual observation after the developing solution was removed from the developing tank.
C: The level at which a developing residue is attached to a plate when the plate is passed through a developing solution without removing the developing solution from the developing solution tank.

### <Evaluation of Film Wearing>

### Evaluation of film wearing caused by development in the exposed area

An automatic processor LP-940H manufactured by FUJIFILM Corporation was loaded with a developing solution DT-2 (1:8 dilution) manufactured by FUJIFILM Corporation and a finisher FG-1 (1:1 dilution) manufactured by FUJIFILM Corporation. After that, using the automatic processor, the non-exposed lithographic printing plate precursor was subjected to a processing procedure under the conditions of developing temperature of 32°C and developing time of 12 seconds. The conductiviy of the developing solution at this time was 43 mS/cm.

Optical densities of the photosensitive layer before and after the development were measured. The film wearing caused by development was determined in terms of a relative density providing that a density before development, from which only the density of the aluminum plate is deducted, is 100%.
AA: 90% or more
A: 85% or more and less than 90%
B: 80% or more and less than 85%
C: less than 80%

### <Evaluation of Printing Durability>

A test pattern was drawn imagewise on the lithographic printing plate precursor under the conditions of beam intensity of 9 w and drum rotation speed of 150 rpm using TRENDSETTER (trade name) manufactured by Creo Products Inc. Subsequently, it was developed using an LP940H PS processor manufactured by FUJIFILM Corporation charged with DT-2 developing solution (diluted so as to have an electrical conductivity of 43 mS/cm) manufactured by FUJIFILM Corporation at a development temperature of 30°C for a development time of 12 seconds. This was used for continuous printing using a Lithron (trade name) printer manufactured by Komori Corporation. The number of sheets that could be printed with sufficient ink density was visually measured, and the printing durability was evaluated. The printing durability was expressed as a relative value when the number for the printing durability of Comparative Example cI-11 (no surfactant) was defined as 1.0. As the test pattern, a solid image (an overall image area) of 2 cm x 2 cm was used. The number of print at the time when generation of graze and blank (or empty) was found by visual evaluation of the printed matter was defined as the print-ending number. At this time, "1.0" corresponded to 40,000 prints.
AA: 90% or more
A: 85% or more and less than 90%
B: 80% or more and less than 85%
C: less than 80%

### <Evaluation of Waste Concentration Suitability>

20 liters of developing waste after running processing was concentrated with a defoamer: a 3% aqueous solution of AF-A manufactured by FUJIFILM Corporation (AF-A diluted with water) using a waste reduction apparatus XR-2000 manufactured by FUJIFILM Graphic Systems Co., Ltd.

Evaluation was conducted in terms of concentration rate and BOD value of the distilled reused water.
AA : The concentration rate is 4 times or more and the BOD value is less than 300 mg/L
AA: concentration rate is 4 times or more, and BOD value is less than 300 mg/L
A: concentration rate is 3 times or more and less than 4 times, and BOD value is less than 300 mg/L
B: concentration rate is 2 times or more and less than 3 times, and BOD value is less than 300 mg/L
C: concentration rate is less than 2 times, and BOD value is less than 300 mg/L
D: concentration rate is less than 2 times, and BOD value is 300 mg/L or more

### (Developing Solution)

| | |
|---|---|
| D-Sorbit | 2.5 mass% |
| Sodium hydroxide | 0.85 mass% |
| Polyethylene glycol lauryl ether (weight average molecular weight: 1,000) | 0.5 mass% |
| Water | 96.15 mass% |

**Table I-2**

| No.^{*2} I-2 | Surfactant | Content^{*1} Mass% | Running residue | Film wearing | Plate durability | Concentration |
|---|---|---|---|---|---|---|
| 101 R | SOFTAZOLINE LPB-R | 3% | B | AA | AA | B |
| 102 R | | 5% | AA | AA | AA | AA |
| 103 R | | 10% | AA | AA | AA | AA |
| 104 R | | 15% | AA | B | B | AA |
| 105 R | SOFTAZOLINE LAO | 3% | B | AA | AA | B |
| 106 R | | 5% | AA | AA | AA | AA |
| 107 R | | 10% | AA | AA | AA | AA |
| 108 R | | 15% | AA | B | B | AA |
| 109 | NEWCOL B4SN | 3% | B | AA | AA | B |
| 110 | | 5% | AA | A | A | A |
| 111 | | 10% | AA | A | A | A |
| 112 | | 15% | AA | B | B | A |
| 113 | PELEX NBL | 3% | B | AA | AA | B |
| 114 | | 5% | AA | A | A | A |
| 115 | | 10% | AA | A | A | A |
| 116 | | 15% | AA | B | B | A |
| c11 | None | None | C | AA | AA | C |
| c12 | Triethanolamine | 5% | C | AA | AA | D |
| c13 | | 10% | C | AA | AA | D |

| | | | | | | |
|---|---|---|---|---|---|---|
| R = Reference Example ·SOFTAZOLINE LPB-R: trade name, amide betaine-type amphoteric surfactant, manufactured by Kawaken Fine Chemicals Co., Ltd. ·SOFTAZOLINE LAO: trade name, amide amine oxide-type amphoteric surfactant, manufactured by Kawaken Fine Chemicals Co., Ltd. ·NEWCOL B4SN: trade name, anionic surfactant, manufactured by Nippon Nyukazai Co., Ltd., R-O-(CH₂CH₂O)ₙ-SO₃Na (R: aryl group, n: integer) ·PELEX NBL: trade name, anionic surfactant, manufactured by Kao Corporation, Sodium Alkylnaphthalenesulfonate *1: It means the content with respect to the total solid content of the recording layer containing a surfactant. The same goes for the following tables. *2: Test Examples having the number beginning with "c" mean Comparative Examples. The same goes for the following Examples and Comparative Examples. | | | | | | |

As is apparent from the above Table, the lithographic printing plate precursors of the present invention drastically improve the running residue and have satisfactory performances without the film wearing, and also exhibit high-plate durability, when compared to those of Comparative Examples. From these results, it is seen that the lithographic printing plate precursors having the recording layer that contains the amphoteric surfactant or the anionic surfactant according to the present invention make it possible to realize good developability in addition to high-plate durability.

### [Example 1-2 and Comparative Example 1-2]

Evaluation was conducted in terms of running residue, film wearing, and plate durability in the same manner as in the above-described Example I-1, except that the polyurethane used was changed from Polyurethane (1) to Polyurethanes (2) to (9), respectively. As a result, it was confirmed that the lithographic printing plate precursors having used the amphoteric surfactant or the anionic surfactant (Examples), in any case of using the above polyurethanes, exhibited the same good performances as those of Example I-1, when compared to the lithographic printing plate precursors free of the amphoteric surfactant or the anionic surfactant (Comparative Examples).

### [Example 1-3 and Comparative Example I-3]

In the above, Examples in which the particular polyurethane and the amphoteric surfactant or the anionic surfactant are contained together in the upper layer were described. Further, it was confirmed that the embodiments of the present invention modified as shown in the following Table 1-3 also exhibited effects as high as those of the above-described Examples I-1 and 1-2. That is, the lithographic printing plate precursors of the present invention exhibited good effects on running residue, film wearing, and plate durability, when compared to Comparative Examples. It is seen that the lithographic printing plate precursors having used the amphoteric surfactant or the anionic surfactant (Examples) exhibited good performances in terms of a good balance between developability and plate durability, when compared to the lithographic printing plate precursors free of the amphoteric surfactant or the anionic surfactant (Comparative Examples). The results are shown together below. Note that the comparative experiments were conducted in each experiment such that the anionic surfactant or the amphoteric surfactant was used in the amount of 10% by mass.

### (Photosensitive Solution L2 for Lower layer) With NVK Resin

| | |
|---|---|
| The above-described polyurethane (1) | 4.17 g |
| The above-described cyanine dye A | 0.94 g |
| Crystal Violet (manufactured by Hodogaya Chemical Co., Ltd.) | 0.08 g |
| m,p-Cresol novolac resin (m/p = 6/4, Mw=3500) | 1.04 g |
| Methyl ethyl ketone | 61.00 g |
| Propylene glycol monomethyl ether | 14.00 g |
| γ-Butyrolactone | 9.40 g |
| Water | 0.03 g |

### (Photosensitive Solution U2 for Upper Layer) With IR Dye/With NVK Resin

| | |
|---|---|
| Polyurethane (1) (25%, 3-pentanone solution) | 30.00 g |
| The above-described cyanine dye A | 0.15 g |
| Ethyl Violet (manufactured by Hodogaya Chemical Co., Ltd.) | 0.03 g |
| Surfactant described in Table 1-3 | 10 mass% |
| Fluorine-based surfactant (trade name: Megafac F-176, manufactured by DIC Corporation) | 0.05 g |
| 3-Pentanone | 62.40 g |
| Propylene glycol monomethylether-2-acetate | 7.37 g |

### (Photosensitive Solution U3 for Upper Layer) With IR Dye/With NVK Resin

| | |
|---|---|
| Polyurethane (1) (25%, 3-pentanone solution) | 24.00 g |
| The above-described cyanine dye A | 0.15 g |
| Ethyl Violet (manufactured by Hodogaya Chemical Co., Ltd.) | 0.03 g |
| Surfactant described in Table 1-3 | 10 mass% |
| Fluorine-based surfactant (trade name: Megafac F-176, manufactured by DIC Corporation) | 0.05 g |
| m,p-Cresol novolac resin (m/p = 6/4, Mw=3500) | 1.50 g |
| 3-Pentanone | 62.40g |
| Propylene glycol monomethylether-2-acetate | 7.37 g |

**Table 1-3**

| No*2 I-3 | PL*3 | | Surfactant | Content* 1 Mass% | Running residue | Film wearing | Plate durability | Concentration |
|---|---|---|---|---|---|---|---|---|
| | UL | LL | | | | | | |
| 301 R | U1 | L2 | SOFTAZOLINE LPB-R | 10% | AA | AA | AA | AA |
| 302 R | | | SOFTAZOLINE LAO | 10% | AA | AA | AA | AA |
| 303 | | | NEWCOL B4SN | 10% | AA | A | A | A |
| 304 | | | PELEX NBL | 10% | AA | A | A | A |
| c31 | | | Triethanolamine | 10% | C | AA | AA | D |
| 311 R | U2 | L1 | SOFTAZOLINE LPB-R | 10% | AA | AA | AA | AA |
| 312 R | | | SOFTAZOLINE LAO | 10% | AA | AA | AA | AA |
| 313 | | | NEWCOL B4SN | 10% | AA | A | A | A |
| 314 | | | PELEX NBL | 10% | AA | A | A | A |
| c32 | | | Triethanolamine | 10% | C | AA | AA | D |
| 321 R | U2 | L2 | SOFTAZOLINE LPB-R | 10% | AA | AA | AA | AA |
| 322 R | | | SOFTAZOLINE LAO | 10% | AA | AA | AA | AA |
| 323 | | | NEWCOL B4SN | 10% | AA | A | A | A |
| 324 | | | TELEX NBL | 10% | AA | A | A | A |
| c33 | | | Triethanolamine | 10% | C | AA | AA | D |
| 331 R | U3 | L1 | SOFTAZOLINE LPB-R | 10% | AA | AA | AA | AA |
| 332 R | | | SOFTAZOLINE LAO | 10% | AA | AA | AA | AA |
| 333 | | | NEWCOL B4SN | 10% | AA | A | A | A |
| 334 | | | PELEX NBL | 10% | AA | A | A | A |
| c34 | | | Triethanolamine | 10% | C | AA | AA | D |
| 341 R | U3 | L2 | SOFTAZOLINE LPB-R | 10% | AA | AA | AA | AA |
| 342 R | | | SOFTAZOLINE LAO | 10% | AA | AA | AA | AA |
| 343 | | | NEWCOL B4SN | 10% | AA | A | A | A |
| 344 | | | PELEX NBL | 10% | AA | A | A | A |
| c35 | | | Triethanolamine | 10% | C | AA | AA | D |

| | | | | | | | | |
|---|---|---|---|---|---|---|---|---|
| *1, and *2 same as above table I-2. *3 PL: Photosensitive Solution, UL: Upper layer, LL: Lower layer R = Reference Example | | | | | | | | |

As is apparent from the above, the lithographic printing plate precursors of the present invention drastically improve the running residue and have satisfactory performances without the film wearing, and also exhibit high-plate durability. From these results, it is seen that the lithographic printing plate precursors having the recording layer that contains the amphoteric surfactant or the anionic surfactant according to the present invention make it possible to realize good developability in addition to high-plate durability.

## Claims

1. An infrared sensitive lithographic printing plate precursor of positive-type comprising a support having a hydrophilic surface and an image recording layer provided on the support comprising:
an anionic surfactant;
an infrared absorbing agent; and
a polyuretheane resin,
wherein the image recording layer has a configuration in which a lower layer on the side of the support and an upper layer on the side opposite thereto are disposed on the support in this order, the upper layer and/or the lower layer comprising the polyurethane resin, the anionic surfactant and the infrared absorbing agent in the same layer, or in a separate layer.

2. An infrared sensitive lithographic printing plate precursor according to Claim 1, wherein the anionic surfactant is represented by any one of formulae (IV) to (VII):
**R⁶-L¹²-D¹** **(IV)**
**R⁷-L¹³-E¹** **(V)**
**R⁸-L¹⁴-F¹** **(VI)**
**R⁹-L¹⁵-G¹-L¹⁶** **(VII)**
wherein R⁶ and R⁹ each represent an alkyl group having 6 to 24 carbon atoms; L¹² represents a phenylene group or a single bond; D¹, E¹ and F¹ each represent an sulfonate ion or a salt thereof, or an phosphate ion or a salt thereof; R⁷ represents an alkyl group having 4 to 18 carbon atoms; L¹³ represents a phenylene group or a naphthylene group; R⁸ represents a phenyl group or a naphthyl group; L¹⁴ represents a polyalkyleneoxy group; L¹⁵ represents a phenylene group; G¹ represents an oxygen atom; and L¹⁶ represents a phenyl group.

3. An infrared sensitive lithographic printing plate precursor according to Claim 1 or Claim 2, wherein the polyurethane resin is a polymerization product of at least a diisocyanate compound selected from the following DI-1 to DI-4 and a diol compound selected from the following DO-1 to DO-5.

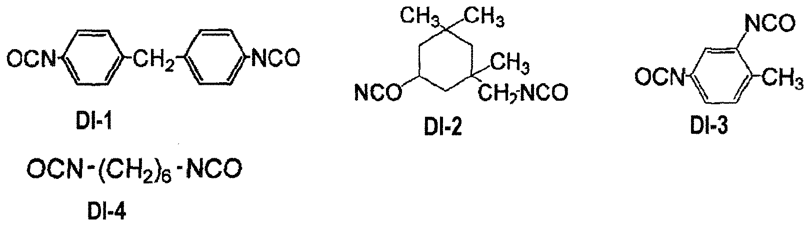

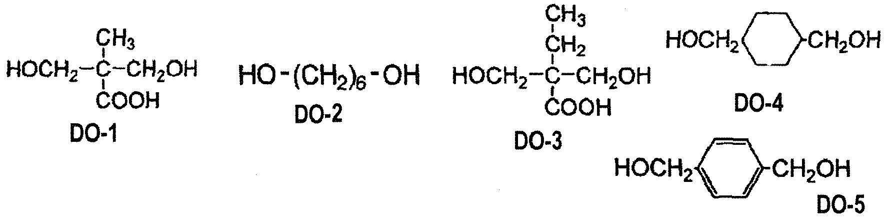

4. An infrared sensitive lithographic printing plate precursor according to any preceding Claim, wherein the anionic surfactant is contained in an amount of 1% by mass or more and less than 20% by mass with respect to the total amount of the solid content of the layer containing the same, and the anionic surfactant and the infrared absorbing agent are contained in the same layer, or in a separate layer.

5. An infrared sensitive lithographic printing plate precursor according to any preceding Claim, wherein the anonic surfactant is contained in an amount of from 0.5% by mass to 40% by mass with respect to 100% by mass of the polyurethane resin.

6. An infrared sensitive lithographic printing plate precursor according to any preceding Claim, further comprising an undercoat layer between the support and the lower layer of the recording layer.

7. An infrared sensitive lithographic printing plate precursor according to any preceding Claim, wherein the polyurethane resin is contained in the upper layer of the recording layer.

8. An infrared sensitive lithographic printing plate precursor according to any preceding Claim, wherein the anionic surfactant is contained in the same layer as the layer containing the polyurethane resin.

9. An infrared sensitive lithographic printing plate precursor according to Claim 1, wherein:
(i) the upper layer of the image recording layer comprises an alkali soluble or dispersible resin, the polyurethane resin, the surfactant and a Novolac resin; and the lower layer of the image recording layer comprises the infrared absorbing agent;
(ii) the upper layer of the image recording layer comprises the polyurethane resin, the surfactant and a Novolac resin; and the lower layer of the image recording layer comprises an alkali soluble or dispersible resin and the infrared absorbing agent;
(iii) the upper layer of the image recording layer comprises an alkali soluble or dispersible resin, the polyurethane resin and a Novolac resin; and the lower layer of the image recording layer comprises the surfactant and the infrared absorbing agent;
(iv) the upper layer of the image recording layer comprises the polyurethane resin and the surfactant; and the lower layer of the image recording layer comprises an alkali soluble or dispersible resin and the infrared absorbing agent;
(v) the upper layer of the image recording layer comprises the polyurethane resin and the surfactant; and the lower layer of the image recording layer comprises an alkali soluble or dispersible resin, a Novolac resin and the infrared absorbing agent; or
(vi) the upper layer of the image recording layer comprises the polyurethane resin, the surfactant and the infrared absorbing agent; and the lower layer of the image recording layer comprises an alkali soluble or dispersible resin, a Novolac resin and the infrared absorbing agent.

10. A method of making a lithographic printing plate comprising:
subjecting the recording layer of the infrared sensitive lithographic printing plate precursor as defined in any preceding Claim to image-wise exposure; and
developing the exposed lithographic printing plate precursor using an aqueous alkaline solution which has a pH of from 11.0 to 13.5.

11. A method of making a lithographic printing plate according to Claim 10, wherein the aqueous alkaline solution comprises an anionic surfactant or a nonionic surfactant.

## Patentansprüche

1. Infrarot-empfindlicher Lithographiedruckplattenvorläufer vom Positivtyp, umfassend einen Träger, der eine hydrophile Oberfläche aufweist, und eine auf dem Träger vorgesehene Bildaufzeichnungsschicht, umfassend:
ein anionisches Tensid;
ein Infrarot-absorbierendes Mittel; und
ein Polyurethanharz,
worin die Bildaufzeichnungsschicht eine Konfiguration aufweist, in der eine untere Schicht auf der Seite des Trägers und eine obere Schicht auf der Seite gegenüberliegend hierzu auf dem Träger in dieser Reihenfolge angeordnet sind, worin die obere Schicht und/oder die untere Schicht das Polyurethanharz, das anionische Tensid und das Infrarot-absorbierende Mittel in der gleichen Schicht oder in einer separaten Schicht umfassen.

2. Infrarot-empfindlicher Lithographiedruckplattenvorläufer gemäß Anspruch 1, worin das anionische Tensid durch eine beliebige der Formeln (IV) bis (VII) dargestellt wird:
**R⁶-L¹²-D¹** **(IV)**
**R⁷-L¹³-E¹** **(V)**
**R⁸-L¹⁴-F¹** **(VI)**
**R⁹-L¹⁵-G¹-L¹⁶** **(VII)**
worin R⁶ und R⁹ jeweils eine Alkylgruppe, die 6 bis 24 Kohlenstoffatome aufweist, darstellen; L¹² eine Phenylengruppe oder eine Einfachbindung darstellt; D¹, E¹ und jeweils ein Sulfonation oder ein Salz davon, oder ein Phosphation oder ein Salz davon darstellen; R⁷ eine Alkylgruppe, die 4 bis 18 Kohlenstoffatome aufweist, darstellt; L¹³ eine Phenylengruppe oder eine Naphthylengruppe darstellt; R⁸ eine Phenylgruppe oder eine Naphthylgruppe darstellt; L¹⁴ eine Polyalkylenoxygruppe darstellt; L¹⁵ eine Phenylengruppe darstellt; G¹ ein Sauerstoffatom darstellt; und L¹⁶ eine Phenylgruppe darstellt.

3. Infrarot-empfindlicher Lithographiedruckplattenvorläufer gemäß Anspruch 1 oder Anspruch 2, worin das Polyurethanharz ein Polymerisationsprodukt von zumindest einer Diisocyanatverbindung, ausgewählt aus den folgenden DI-1 bis DI-4 und einer Diolverbindung, ausgewählt aus den folgenden DO-1 bis DO-5, ist.

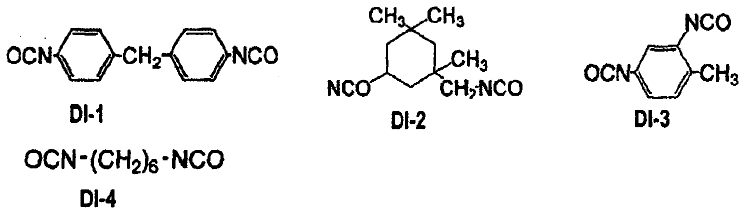

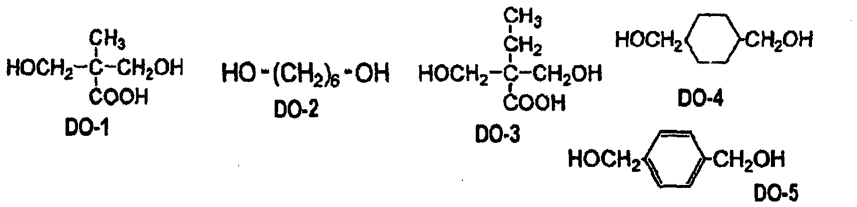

4. Infrarot-empfindlicher Lithographiedruckplattenvorläufer gemäß irgendeinem vorhergehenden Anspruch, worin das anionische Tensid in einer Menge von 1 Masse% oder mehr und weniger als 20 Masse% in Bezug auf die Gesamtmenge des Feststoffgehalts der Schicht, die es enthält, enthalten ist, und das anionische Tensid und das Infrarot-absorbierende Mittel in der gleichen Schicht oder in einer separaten Schicht enthalten sind.

5. Infrarot-empfindlicher Lithographiedruckplattenvorläufer gemäß irgendeinem vorhergehenden Anspruch, worin das Tensid in einer Menge von 0,5 Masse% bis 40 Masse% in Bezug auf 100 Masse% des Polyurethanharzes enthalten ist.

6. Infrarot-empfindlicher Lithographiedruckplattenvorläufer gemäß irgendeinem vorhergehenden Anspruch, ferner umfassend eine Grundierungsschicht zwischen dem Träger und der unteren Schicht der Aufzeichnungsschicht.

7. Infrarot-empfindlicher Lithographiedruckplattenvorläufer gemäß irgendeinem vorhergehenden Anspruch, worin das Polyurethanharz in der oberen Schicht der Aufzeichnungsschicht enthalten ist.

8. Infrarot-empfindlicher Lithographiedruckplattenvorläufer gemäß irgendeinem vorhergehenden Anspruch, worin das anionische Tensid in der gleichen Schicht enthalten ist, wie die Schicht, die das Polyurethanharz enthält.

9. Infrarot-empfindlicher Lithographiedruckplattenvorläufer gemäß Anspruch 1, worin:
(i) die obere Schicht der Bildaufzeichnungsschicht ein alkalilösliches oder dispergierbares Harz, das Polyurethanharz, das Tensid und ein NovolakHarz umfasst; und die untere Schicht der Bildaufzeichnungsschicht das Infrarot-absorbierende Mittel umfasst;
(ii) die obere Schicht der Bildaufzeichnungsschicht das Polyurethanharz, das Tensid und ein NovolakHarz umfasst; und die untere Schicht der Bildaufzeichnungsschicht ein alkalilösliches oder dispergierbares Harz und das Infrarot-absorbierende Mittel umfasst;
(iii) die obere Schicht der Bildaufzeichnungsschicht ein alkalilösliches oder dispergierbares Harz, das Polyurethanharz und ein Novolak-Harz umfasst; und die untere Schicht der Bildaufzeichnungsschicht das Tensid und das Infrarot-absorbierende Mittel umfasst;
(iv) die obere Schicht der Bildaufzeichnungsschicht das Polyurethanharz und das Tensid umfasst; und die untere Schicht der Bildaufzeichnungsschicht ein alkalilösliches oder dispergierbares Harz und das Infrarot-absorbierende Mittel umfasst;
(v) die obere Schicht der Bildaufzeichnungsschicht das Polyurethanharz und das Tensid umfasst; und die untere Schicht der Bildaufzeichnungsschicht ein alkalilösliches der dispergierbares Harz, ein Novolak-Harz und das Infrarot-absorbierende Mittel umfasst; oder
(vi) die obere Schicht der Bildaufzeichnungsschicht das Polyurethanharz, das Tensid und das Infrarot-absorbierende Mittel umfasst; und die untere Schicht der Bildaufzeichnungsschicht ein alkalilösliches oder dispergierbares Harz, ein Novolak-Harz und das Infrarot-absorbierende Mittel umfasst.

10. Verfahren zur Herstellung einer Lithographiedruckplatte, umfassend:
Unterziehen der Aufzeichnungsschicht des Infrarotempfindlichen Lithographiedruckplattenvorläufers wie in irgendeinem vorhergehenden Anspruch definiert einer bildweisen Belichtung; und
Entwickeln des belichteten Lithograplziedruckplattenvorläufers unter Verwendung einer wässrigen alkalischen Lösung, die einen pH-Wert von 11,0 bis 13,5 aufweist.

11. Verfahren zur Herstellung einer Lithographiedruckplatte gemäß Anspruch 10, worin die wässrige alkalische Lösung ein anionisches Tensid oder ein nicht-ionisches Tensid umfasst.

## Revendications

1. Précurseur de plaque d'impression lithographique sensible aux infrarouges de type positif, comprenant un support possédant une surface hydrophile et une couche d'enregistrement d'image disposée sur le support comprenant :
un tensioactif anionique ;
un agent absorbant les infrarouges ; et
une résine de polyuréthane,
dans lequel la couche d'enregistrement d'image présente une configuration dans laquelle une couche inférieure du côté du support et une couche supérieure du côté opposé à ce dernier sont disposées sur le support dans cet ordre, la couche supérieure et/ou la couche inférieure comprenant la résine de polyuréthane, le tensioactif anionique et l'agent absorbant les infrarouges dans la même couche ou dans une couche séparée.

2. Précurseur de plaque d'impression lithographique sensible aux infrarouges selon la revendication 1, dans lequel le tensioactif anionique est représenté par les formules (IV) à (VII) :
**R⁶-L¹²-D¹** **(IV)**
**R⁷-L¹³-E¹** **(V)**
**R⁸-L¹⁴-F¹** **(VI)**
**R⁸-L¹⁵-G¹-L¹⁶** **(VII)**
dans lesquelles R⁶ et R⁹ représentent chacun un groupe alkyle contenant 6 à 24 atomes de carbone ; L¹² représente un groupe phénylène ou une liaison simple ; D¹, E¹ et F¹ représentent chacun un ion sulfonate ou un sel de celui-ci, ou un ion phosphate ou un sel de celui-ci ; R⁷ représente un groupe alkyle contenant 4 à 18 atomes de carbone ; L¹³ représente un groupe phénylène ou un groupe naphtylène ; R⁸ représente un groupe phényle ou un groupe naphtyle ; L¹⁴ représente un groupe polyalkylèneoxy ; L¹⁵ représente un groupe phénylène ; G¹ représente un atome d'oxygène ; et L¹⁶ représente un groupe phényle.

3. Précurseur de plaque d'impression lithographique sensible aux infrarouges selon la revendication 1 ou 2, dans lequel la résine de polyuréthane est un produit issu de la polymérisation d'au moins un composé de diisocyanate choisi parmi DI-1 à DI-4 suivants et d'un composé diol choisi parmi DO-1 à DO-5 suivants.

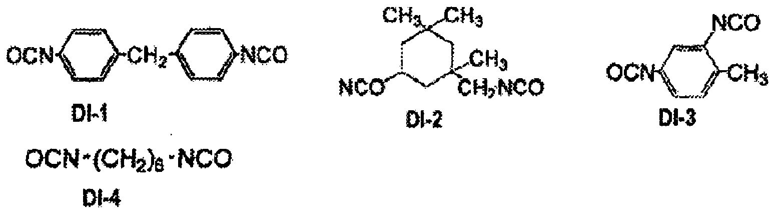

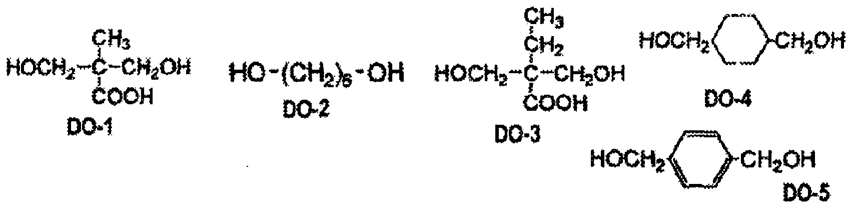

4. Précurseur de plaque d'impression lithographique sensible aux infrarouges selon l'une quelconque des revendications précédentes, dans lequel le tensioactif anionique est contenu en une quantité supérieure ou égale à 1 % en masse et inférieure à 20 % en masse par rapport à la quantité totale de la teneur en solides de la couche le contenant, et le tensioactif anionique et l'agent absorbant les infrarouges sont contenus dans la même couche ou dans une couche séparée.

5. Précurseur de plaque d'impression lithographique sensible aux infrarouges selon l'une quelconque des revendications précédentes, dans lequel le tensioactif anionique est contenu en une quantité de 0,5 % en masse à 40 % en masse par rapport à 100 % en masse de la résine de polyuréthane.

6. Précurseur de plaque d'impression lithographique sensible aux infrarouges selon l'une quelconque des revendications précédentes, comprenant en outre une sous-couche entre le support et la couche inférieure de la couche d'enregistrement.

7. Précurseur de plaque d'impression lithographique sensible aux infrarouges selon l'une quelconque des revendications précédentes, dans lequel la résine de polyuréthane est contenue dans la couche supérieure de la couche d'enregistrement.

8. Précurseur de plaque d'impression lithographique sensible aux infrarouges selon l'une quelconque des revendications précédentes, dans lequel le tensioactif anionique est contenu dans la même couche que la couche contenant la résine de polyuréthane.

9. Précurseur de plaque d'impression lithographique sensible aux infrarouges selon la revendication 1, dans lequel :
(i) la couche supérieure de la couche d'enregistrement d'image comprend une résine soluble ou dispersible dans les alcalins, la résine de polyuréthane, le tensioactif et une résine novolaque ; et la couche inférieure de la couche d'enregistrement d'image comprend l'agent absorbant les infrarouges ;
(ii) la couche supérieure de la couche d'enregistrement d'image comprend la résine de polyuréthane, le tensioactif et une résine novolaque ; et la couche inférieure de la couche d'enregistrement d'image comprend une résine soluble ou dispersible dans les alcalins et l'agent absorbant les infrarouges ;
(iii) la couche supérieure de la couche d'enregistrement d'image comprend une résine soluble ou dispersible dans les alcalins, la résine de polyuréthane et une résine novolaque ; et la couche inférieure de la couche d'enregistrement d'image comprend le tensioactif et l'agent absorbant les infrarouges ;
(iv) la couche supérieure de la couche d'enregistrement d'image comprend la résine de polyuréthane et le tensioactif; et la couche inférieure de la couche d'enregistrement d'image comprend une résine soluble ou dispersible dans les alcalins et l'agent absorbant les infrarouges ;
(v) la couche supérieure de la couche d'enregistrement d'image comprend la résine de polyuréthane et le tensioactif ; et la couche inférieure de la couche d'enregistrement d'image comprend une résine soluble ou dispersible dans les alcalins, une résine novolaque et l'agent absorbant les infrarouges ; ou
(vi) la couche supérieure de la couche d'enregistrement d'image comprend la résine de polyuréthane, le tensioactif et l'agent absorbant les infrarouges ; et la couche inférieure de la couche d'enregistrement d'image comprend une résine soluble ou dispersible dans les alcalins, une résine novolaque et l'agent absorbant les infrarouges.

10. Procédé de préparation d'une plaque d'impression lithographique, comprenant :
la soumission de la couche d'enregistrement du précurseur de plaque d'impression lithographique sensible aux infrarouges tel que défini dans l'une quelconque des revendications précédentes à une exposition selon une image ; et
le développement du précurseur de plaque d'impression lithographique exposé au moyen d'une solution alcaline aqueuse ayant un pH de 11,0 à 13,5.

11. Procédé de préparation d'une plaque d'impression lithographique selon la revendication 10, dans lequel la solution alcaline aqueuse comprend un tensioactif anionique ou un tensioactif non ionique.
